# EUROPEAN PATENT APPLICATION

(11) **EP 4 484 499 A1**
(43) Date of publication of application: **01.01.2025**
(21) Application number: 23759517.8
(22) Date of filing: 17.01.2023
(51) Int. Cl.: C08L 101/00, C08K 3/10, C08K 3/22, C08L 63/00, H01F 1/147, H01F 1/26, H01F 1/37, H05K 1/16

(54) **RESIN COMPOSITION**

(30) Priority: 24.02.2022 JP 2022027074
(71) Applicant: AJINOMOTO CO., INC., Chuo-ku Tokyo 104-8315 (JP)
(72) Inventor: OOYAMA, Hideki, Kawasaki-shi, Kanagawa 210-0801 (JP); TANAKA, Takayuki, Kawasaki-shi, Kanagawa 210-0801 (JP); MORIMOTO, Shunsuke, Kawasaki-shi, Kanagawa 210-0801 (JP)
(74) Representative: Mewburn Ellis LLP
(86) International application number: PCT/JP2023/001120
(87) International publication number: WO 2023/162511

(57) **Abstract**

A resin composition comprising (A) a Fe-Ni-Si type alloy magnetic powder and (B) a thermosetting resin, wherein an amount of Si included in the (A) component is 10 by mass to 8% by mass relative to 100% mass of the (A) component.

## Description

### Technical Field

The present invention relates to a resin composition, as well as a cured product, a magnetic paste, a resin sheet, a circuit board, and an inductor substrate, these all using said resin composition.

### Background Art

As a core material for an inductor component, a cured product obtained by curing a resin composition that contains a magnetic powder has been used in a certain case. As for the magnetic powder, a FeNi alloy powder has been used in a certain case (Patent Literature 1).

### Citation List

### Patent Literature

Patent Literature 1: Japanese Patent Application Laid-open No. 2018-178254

### Summary of the Invention

### Technical Problem

Conventionally, an independent inductor component has been generally mounted on a substrate for a semiconductor device. However, in recent years, a method for forming a coil as a conductor pattern of the substrate to form an inductor element inside the substrate has been used in a certain case. In order to further improve the performance of the inductor element that is used in such an application, it is required to further improve magnetic properties of a core material. Specifically, it is required to develop a technology that is capable of realizing a core material having a high relative magnetic permeability and a low magnetic loss by means of a cured product of a resin composition that contains a magnetic powder.

The present invention has been conceived in view of the problem described above, and thus, an object of the present invention is to provide: a resin composition from which a cured product having a relative magnetic permeability and a magnetic loss improved can be obtained; a cured product of the resin composition; a magnetic paste and a resin sheet that contain the resin composition; and a circuit board and an inductor substrate that contain the cured product of the resin composition.

### Solution to Problem

The inventor of the present invention has extensively studied how to overcome the problem described above. As a result, the inventor has found that a resin composition that contains a combination of (A) a Fe-Ni-Si type alloy magnetic powder containing a particular amount of Si and (B) a thermosetting resin can overcome the problem described above. On the basis of this finding, the present invention has been completed. Namely, the present invention includes the following aspects.
<1> A resin composition comprising (A) a Fe-Ni-Si type alloy magnetic powder and (B) a thermosetting resin, wherein
   an amount of Si included in the (A) component is 1% by mass to 8% by mass relative to 100% mass of the (A) component.
<2> The resin composition according to <1>, wherein an amount of the (A) component is 40% by mass or more relative to 100% by mass of nonvolatile components in the resin composition.
<3> The resin composition according to <1> or <2>, wherein an amount of the (A) component is 30% by volume or more relative to 100% by volume of nonvolatile components in the resin composition.
<4> The resin composition according to any one of <1> to <3>, wherein an average particle diameter of the (A) component is 1 µm or more.
<5> The resin composition according to any one of <1> to <4>, wherein an average particle diameter of the (A) component is 10 µm or less.
<6> The resin composition according to any one of <1> to <5>, further comprising (C) a magnetic powder other than the Fe-Ni-Si type alloy magnetic powder.
<7> The resin composition according to <6>, wherein the (C) component comprises an alloy magnetic powder other than the Fe-Ni-Si type alloy magnetic powder.
<8> The resin composition according to <6> or <7>, wherein the (C) component comprises a ferrite type magnetic powder.
<9> The resin composition according to any one of <6> to <8>, wherein the (C) component comprises a ferrite type magnetic powder containing at least one element selected from the group consisting of Mn, Zn, Ni, and Cu.
<10> The resin composition according to any one of <6> to <9>, wherein the (C) component has a smaller average particle diameter than the (A) component.
<11> The resin composition according to any one of <6> to <10>, wherein a ratio (average particle diameter of the (C) component / average particle diameter of the (A) component) of an average particle diameter of the (C) component with respect to an average particle diameter of the (A) component is 0.001 to 0.9.
<12> The resin composition according to any one of <6> to <11>, wherein a volume ratio ((C) component / (A) component) of the (C) component with respect to the (A) component is 0.01 to 0.9.
<13> The resin composition according to any one of <6> to <12>, wherein a total amount of the (A) component and the (C) component is 70% by mass or more relative to 100% by mass of nonvolatile components in the resin composition.
<14> The resin composition according to any one of <6> to <13>, wherein a total amount of the (A) component and the (C) component is 50% by volume or more relative to 100% by volume of nonvolatile components in the resin composition.
<15> The resin composition according to any one of <1> to <14>, wherein the (B) component comprises an epoxy resin.
<16> The resin composition according to any one of <1> to <15>, further comprising (D) a thermoplastic resin.
<17> The resin composition according to any one of <1> to <16>, wherein the resin composition is for filling of a hole.
<18> A cured product of the resin composition according to any one of <1> to <17>.
<19> A magnetic paste comprising the resin composition according to any one of <1> to <17>.
<20> A resin sheet comprising:
   a support; and
   a resin composition layer formed on the support, wherein
   the resin composition layer comprises the resin composition according to any one of <1> to <17>.
<21> A circuit board comprising:
   a substrate having a hole; and
   a cured product of the resin composition according to any one of <1> to <17> filled in the hole.
<22> A circuit board comprising a cured product layer that comprises a cured product of the resin composition according to any one of <1> to <17>.
<23> An inductor substrate comprising the circuit board according to <21> or <22>.

### Advantageous Effects of Invention

According to the present invention, it is possible to provide: a resin composition from which a cured product having a relative magnetic permeability and a magnetic loss improved can be obtained; a cured product of the resin composition; a magnetic paste and a resin sheet that contain the resin composition; and a circuit board and an inductor substrate that contain the cured product of the resin composition.

### Brief Description of Drawings

FIG. 1 is a schematic cross sectional view illustrating the core substrate that is prepared in the production method of the circuit board according to the first example of one embodiment of the present invention.
FIG. 2 is a schematic cross sectional view illustrating the core substrate formed with a through hole in the production method of the circuit board according to the first example of one embodiment of the present invention.
FIG. 3 is a schematic cross sectional view illustrating the core substrate formed with a plated layer in the through hole in the production method of the circuit board according to the first example of one embodiment of the present invention.
FIG. 4 is a schematic cross sectional view illustrating the state of the through hole in the core substrate filled with the resin composition in the production method of the circuit board according to the first example of one embodiment of the present invention.
FIG. 5 is a schematic cross sectional view to explain the step (2) in the production method of the circuit board according to the first example of one embodiment of the present invention.
FIG. 6 is a schematic cross sectional view to explain the step (3) in the production method of the circuit board according to the first example of one embodiment of the present invention.
FIG. 7 is a schematic cross sectional view to explain the step (5) in the production method of the circuit board according to the first example of one embodiment of the present invention.
FIG. 8 is a schematic cross sectional view to explain the step (5) in the production method of the circuit board according to the first example of one embodiment of the present invention.
FIG. 9 is a schematic cross sectional view to explain the step (i) in the production method of the circuit board according to the second example of one embodiment of the present invention.
FIG. 10 is a schematic cross sectional view to explain the step (i) in the production method of the circuit board according to the second example of one embodiment of the present invention.
FIG. 11 is a schematic cross sectional view to explain the step (ii) in the production method of the circuit board according to the second example of one embodiment of the present invention.
FIG. 12 is a schematic cross sectional view to explain the step (iv) in the production method of the circuit board according to the second example of one embodiment of the present invention.
FIG. 13 is a schematic plan view of the circuit board that possessed by the inductor substrate, observed from one side in the thickness direction thereof.
FIG. 14 is a schematic view illustrating the cut end face of a circuit board that is cut at the position indicated by the II-II single-dotted line in FIG. 13.
FIG. 15 is a schematic plan view to explain the composition of the first conductor layer of the circuit board included in the inductor substrate.

### Description of Embodiments

Hereinafter, the present invention will be described in detail in line with preferable embodiments. Note that the present invention is not limited to the embodiments and examples described below; thus, the present invention may be carried out with any modification so far as such modification is not outside the claims or the equivalents thereof.

In the explanation hereinafter, "a resin component" in the resin composition means the components excluding inorganic particles such as a magnetic powder from nonvolatile components included in the resin composition.

In the explanation described hereinafter, "magnetic permeability" means "relative magnetic permeability" unless otherwise specifically mentioned.

### <Outline of Resin Composition>

The resin composition according to one embodiment of the present invention includes (A) a Fe-Ni-Si type alloy magnetic powder and (B) a thermosetting resin. (A) The Fe-Ni-Si type alloy magnetic powder represents a powder of an alloy containing Fe, Ni, and Si. (A) The Fe-Ni-Si type alloy magnetic powder contains Si in the particular amount range of 1% by mass to 8% by mass, relative to 100% by mass of (A) the Fe-Ni-Si type alloy magnetic powder.

According to the resin composition described above, the relative magnetic permeability and the magnetic loss of the cured product of the resin composition can be improved. Specifically, the relative magnetic permeability of the cured product can be increased and the magnetic loss thereof can be decreased.

The inventor presumes the mechanism, by which such superior effects can be obtained by the resin composition according to the present embodiment, as follows.

In general, a FeNi alloy has a crystal structure formed of Fe and Ni, so that the FeNi alloy has a high crystallinity. Therefore, the FeNi alloy tends to have a high relative magnetic permeability and a high magnetic loss. In contrast, when Si is introduced into the FeNi alloy, the crystal structures of Fe and of Ni is distorted. Therefore, it has been expected that, when the amount of Si introduced is increased, the distortion of the crystal structures of Fe and of Ni increases thereby resulting in the greater decrease in the relative magnetic permeability and the magnetic loss. However, the present inventor has found that, when the amount of Si introduced is within the particular range of 1% by mass to 8% by mass, the decrease amount of the relative magnetic permeability can be reduced while the decrease amount of the magnetic loss can be increased. Therefore, (A) the Fe-Ni-Si type alloy magnetic powder containing Si in the particular amount range is possible to exhibit the unique action that the magnetic loss can be effectively reduced due to Si while exhibiting a high relative magnetic permeability due to the crystal structures of Fe and Ni. Therefore, owing to the above-mentioned unique action of (A) the Fe-Ni-Si type alloy magnetic powder, the cured product of the resin composition described above has well-balanced improvements in the relative magnetic permeability and the magnetic loss as compared with a cured product of a conventional resin composition containing a magnetic powder.

However, the technical scope of the present invention is not restricted by the mechanism described above. In the explanation of the above mechanism, the case that Si is introduced into the FeNi alloy is illustrated as an example, but there is no limitation in the production method of (A) the Fe-Ni-Si type alloy magnetic powder. Therefore, those that are produced by a method other than the method in which Si is introduced into the FeNi alloy is also included in (A) the Fe-Ni-Si type alloy magnetic powder.

### <(A) Fe-Ni-Si Type Alloy Magnetic Powder>

The resin composition according to the present embodiment includes (A) a Fe-Ni-Si type magnetic powder as the (A) component. Therefore, (A) the Fe-Ni-Si type alloy magnetic powder includes Fe, Ni, and Si in combination.

The amount of Si included in (A) the Fe-Ni-Si type alloy magnetic powder is usually 1% by mass or more, preferably 2% by mass or more, and especially preferably 3% by mass or more, and is usually 8% by mass or less, more preferably 7% by mass or less, and especially preferably 6% by mass or less, relative to 100% by mass of (A) the Fe-Ni-Si type alloy magnetic powder. When the amount of Si is within the range described above, the cured product of the resin composition can achieve high relative magnetic permeability and low magnetic loss which are well balanced.

The mass ratio (Si/Fe) of the amount of Si with respect to the amount of Fe in (A) the Fe-Ni-Si type alloy magnetic powder is preferably 0.01 or more, more preferably 0.02 or more, and especially preferably 0.04 or more, and is preferably 0.17 or less, more preferably 0.16 or less, and especially preferably 0.14 or less. When the ratio (Si/Fe) of the amount of Si with respect to the amount of Fe is within the range described above, the relative magnetic permeability and the magnetic loss of the cured product of the resin composition can be effectively improved.

The mass ratio (Si/Ni) of the amount of Si with respect to the amount of Ni in (A) the Fe-Ni-Si type alloy magnetic powder is preferably 0.01 or more, more preferably 0.02 or more, and especially preferably 0.04 or more, and is preferably 0.21 or less, more preferably 0.20 or less, and especially preferably 0.18 or less. When the ratio (Si/Ni) of the amount of Si with respect to the amount of Ni is within the range described above, the relative magnetic permeability and the magnetic loss of the cured product of the resin composition can be effectively improved.

The amount of Fe included in (A) the Fe-Ni-Si type alloy magnetic powder is preferably 33.00% by mass or more, more preferably 38.00% by mass or more, still more preferably 43.00% by mass or more, and especially preferably 48.00% by mass or more, and is preferably 65.00% by mass or less, more preferably 60.00% by mass or less, still more preferably 55.00% by mass or less, and especially preferably 52.00% by mass or less, relative to 100% by mass of (A) the Fe-Ni-Si type alloy magnetic powder. When the amount of Fe is within the range described above, the relative magnetic permeability and the magnetic loss of the cured product of the resin composition can be effectively improved.

The amount of Ni included in (A) the Fe-Ni-Si type alloy magnetic powder is preferably 33.00% by mass or more, more preferably 38.00% by mass or more, still more preferably 40.00% by mass or more, and especially preferably 42.00% by mass or more, and is preferably 65.00% by mass or less, more preferably 60.00% by mass or less, still more preferably 54.00% by mass or less, and especially preferably 49.00% by mass or less, relative to 100% by mass of (A) the Fe-Ni-Si type alloy magnetic powder. When the amount of Ni is within the range described above, the relative magnetic permeability and the magnetic loss of the cured product of the resin composition can be effectively improved.

The total amount of Fe and Ni included in (A) the Fe-Ni-Si type alloy magnetic powder is preferably 85% by mass or more, more preferably 87% by mass or more, and especially preferably 92% by mass or more, and is preferably 99% by mass or less, more preferably 98.5% by mass or less, and especially preferably 98% by mass or less, relative to 100% by mass of (A) the Fe-Ni-Si type alloy magnetic powder. When the total amount of Fe and Ni is within the range described above, the relative magnetic permeability and the magnetic loss of the cured product of the resin composition can be effectively improved.

The mass ratio (Fe/Ni) of the amount of Fe with respect to the amount of Ni included in (A) the Fe-Ni-Si type alloy magnetic powder is preferably 0.5 or more, more preferably 0.7 or more, and especially preferably 1.0 or more, and is preferably 1.21 or less, more preferably 1.20 or less, and especially preferably 1.19 or less. When the ratio (Fe/Ni) of the amount of Fe with respect to the amount of Ni is within the range described, the relative magnetic permeability and the magnetic loss of the cured product of the resin composition can be effectively improved.

(A) The Fe-Ni-Si type alloy magnetic powder may contain an optional element other than Fe, Ni and Si. Examples of the optional element may include those that are derived from impurities that may be unavoidably mixed in accordance with the production method of (A) the Fe-Ni-Si type alloy magnetic powder. Illustrative examples of the optional element may include P, S, Mn, Cr, Mo, Cu, and Co. However, from the viewpoint of significantly exhibiting the advantageous effects of the present invention, it is preferable that (A) the Fe-Ni-Si type alloy magnetic powder does not contain the optional element other than Fe, Ni, and Si. Therefore, it is preferable that (A) the Fe-Ni-Si type alloy magnetic powder contains only Fe, Ni, and Si.

The amount of Fe, Ni, and Si included in (A) the Fe-Ni-Si type alloy magnetic powder can be measured by an inductively coupled plasma emission spectrometer (e.g., "ICP-OES 720ES" manufactured by Agilent Technologies, Inc.).

The average particle diameter D50 of (A) the Fe-Ni-Si type alloy magnetic powder is preferably 1 µm or more, more preferably 2 µm or more, and especially preferably 3 µm or more. When the average particle diameter D50 of (A) the Fe-Ni-Si type alloy magnetic powder is equal to or more than the lower limit described above, this is preferable in terms of safety when handling (A) the Fe-Ni-Si type alloy magnetic powder. Furthermore, when the average particle diameter D50 of (A) the Fe-Ni-Si type alloy magnetic powder is equal to or more than the lower limit described above, it is possible to mix (A) the Fe-Ni-Si type alloy magnetic powder and a resin component including (B) the thermosetting resin with a high uniformity, so that localization of (A) the Fe-Ni-Si type alloy magnetic powder due to agglomeration can be effectively suppressed. Therefore, the relative magnetic permeability and the magnetic loss of the cured product can be effectively improved. The upper limit of the average particle diameter D50 of (A) the Fe-Ni-Si type alloy magnetic powder is preferably 10 µm or less, more preferably 9 µm or less, and especially preferably 7 µm or less. When the average particle diameter D50 of (A) the Fe-Ni-Si type alloy magnetic powder is equal to or less than the upper limit described above, the particle of (A) the Fe-Ni-Si type alloy magnetic powder can be small. Therefore, generation of a large eddy current loss due to giant particles can be suppressed, thereby realizing an effective decrease in the magnetic loss. This action is effective especially when the amount of (A) the Fe-Ni-Si type alloy magnetic powder is large.

The average particle diameter D50 of (A) the Fe-Ni-Si type alloy magnetic powder represents the median diameter on a volume basis, unless otherwise specifically mentioned. The average particle diameter D50 can be measured with a laser diffraction scattering method based on the Mie scattering theory. Specifically, the particle diameter distribution thereof is prepared on a volume basis by using a laser diffraction scattering type particle diameter distribution analyzer, in which the median diameter D50 thereof can be measured as the average particle diameter. The powders that are dispersed in water by means of an ultrasonic wave can be suitably used as the measurement sample. Illustrative examples of the laser diffraction scattering type particle diameter distribution analyzer that can be used may include "LA-500" manufactured by Horiba Ltd. and "SALD-2200" manufactured by Shimadzu Corp.

The specific surface area of (A) the Fe-Ni-Si type alloy magnetic powder is preferably 0.05 m²/g or more, more preferably 0.1 m²/g or more, and still more preferably 0.5 m²/g or more, and is preferably 20 m²/g or less, more preferably 10 m²/g or less, and still more preferably 5 m²/g or less. When the specific surface area of (A) the Fe-Ni-Si type alloy magnetic powder is within the range described above, the relative magnetic permeability and the magnetic loss of the cured product of the resin composition can be effectively improved. The specific surface area of the magnetic powder can be measured by the BET method. Specifically, the BET specific surface area can be measured according to the BET method by adsorbing a nitrogen gas onto the sample surface using a specific surface area measurement instrument ("Macsorb HM Model 1210" manufactured by Mountech Co., Ltd.) with the BET multipoint method.

The particle of (A) the Fe-Ni-Si type alloy magnetic powder is preferably spherical. According to the inventor's study, the particle of (A) the Fe-Ni-Si type alloy magnetic powder containing Si can usually have a shape with less surface irregularities than the particle of the FeNi alloy powder not containing Si; thus this can have a shape close to spherical.

The value (aspect ratio) that is obtained by dividing the length of the longitude axis by the length of the short axis of the particle of (A) the Fe-Ni-Si type alloy magnetic powder is preferably 2 or less, more preferably 1.6 or less, and still more preferably 1.4 or less. When the aspect ratio of (A) the Fe-Ni-Si type alloy magnetic powder is within the range described above, the magnetic loss can be suppressed and the viscosity of the resin composition can be lowered.

There is no particular restriction in the production method of (A) the Fe-Ni-Si type alloy magnetic powder. (A) The Fe-Ni-Si type alloy magnetic powder can be produced, for example, by an atomizing method. In this atomizing method, (A) the Fe-Ni-Si type alloy magnetic powder is obtained by a method that usually includes dropping a molten material containing molten iron, nickel, and Si and blowing a highly pressurized water or gas toward the material thereby rapidly cooling down to solidify them. Among the above-mentioned atomizing methods, the water atomizing method, in which water is blown to the dropping molten material, is preferable. As for the atomizing method as described above, for example, the method described in Japanese Patent Application Laid-open No. 2018-178254 may be used.

The amount (% by volume) of (A) the Fe-Ni-Si type alloy magnetic powder included in the resin composition is preferably 30% by volume or more, more preferably 40% by volume or more, and especially preferably 50% by volume or more, and is preferably 90% by volume or less, more preferably 80% by volume or less, and especially preferably 70% by volume or less, relative to 100% by volume of the nonvolatile components included in the resin composition. When the amount of (A) the Fe-Ni-Si type alloy magnetic powder is within the range described above, the relative magnetic permeability and the magnetic loss of the cured product of the resin composition can be effectively improved. When the amount of (A) the Fe-Ni-Si type alloy magnetic powder is equal to or less than the upper limit of the range described above, usually the viscosity of the resin composition can be effectively lowered, so that the resin composition can be made readily pasty.

The amount of each component on the volume basis (% by volume) included in the resin composition can be determined by calculation from the mass of the component included in the resin composition. Specifically, the volume of each component is obtained by dividing the mass with the specific gravity; and the amount on the volume basis (% by volume) can be calculated from the volume of each component thus obtained.

The amount (% by mass) of (A) the Fe-Ni-Si type alloy magnetic powder included in the resin composition is preferably 40% by mass or more, more preferably 50% by mass or more, and especially preferably 60% by mass or more, and is preferably 95% by mass or less, more preferably 90% by mass or less, and especially preferably 80% by mass or less, relative to 100% by mass of the nonvolatile components included in the resin composition. When the amount of (A) the Fe-Ni-Si type alloy magnetic powder is within the range described above, the relative magnetic permeability and the magnetic loss of the cured product of the resin composition can be effectively improved. When the amount of (A) the Fe-Ni-Si type alloy magnetic powder is equal to or less than the upper limit of the range described above, usually the viscosity of the resin composition can be effectively lowered, so that the resin composition can be made readily pasty.

The total amount of the magnetic powder included in the resin composition is usually expressed as the sum of (A) the Fe-Ni-Si type alloy magnetic powder and (C) an optional magnetic powder to be described later. The total amount (% by volume) of the magnetic powder included in the resin composition is preferably 50% by volume or more, more preferably 60% by volume or more, still more preferably 650 by volume or more, and especially preferably 70% by volume or more, and is preferably 90% by volume or less, more preferably 86% by volume or less, and especially preferably 82% by volume or less, relative to 100% by volume of the nonvolatile components in the resin composition. When the total amount of the magnetic powder is within the range described above, the relative magnetic permeability and the magnetic loss of the cured product of the resin composition can be effectively improved. When the total amount of the magnetic powder is equal to or less than the upper limit of the range described above, usually the viscosity of the resin composition can be effectively lowered, so that the resin composition can be made readily pasty.

The total amount of the magnetic powder included in the resin composition is usually expressed as the sum of (A) the Fe-Ni-Si type alloy magnetic powder and (C) the optional magnetic powder to be described later. The total amount (% by mass) of the magnetic powder included in the resin composition is preferably 70% by mass or more, more preferably 80% by mass or more, still more preferably 850 by mass or more, and especially preferably 90% by mass or more, and is preferably 99% by mass or less, more preferably 98% by mass or less, and especially preferably 97% by mass or less, relative to 100% by mass of the nonvolatile components in the resin composition. When the total amount of the magnetic powder is within the range described above, the relative magnetic permeability and the magnetic loss of the cured product of the resin composition can be effectively improved. When the total amount of the magnetic powder is equal to or less than the upper limit of the range described above, usually the viscosity of the resin composition can be effectively lowered, so that the resin composition can be made readily pasty.

### <(B) Thermosetting Resin>

The resin composition according to one embodiment of the present invention includes (B) a thermosetting resin as the (B) component. Usually, (B) the thermosetting resin can bind magnetic powders such as (A) the Fe-Ni-Si type alloy magnetic powder. In addition, (B) the thermosetting resin can usually react by heat to form a bond thereby being cured. Thus, the cured product can be obtained by curing the resin composition containing (A) the Fe-Ni-Si type magnetic powder and (B) the thermosetting resin in combination. This cured product is excellent in the relative magnetic permeability and the magnetic loss, and thus an excellent magnetic layer can be formed.

Illustrative examples of (B) the thermosetting resin may include an epoxy resin, a phenol type resin, an active ester type resin, an amine type resin, an acid anhydride type resin, a benzoxazine type resin, a cyanate ester type resin, and a carbodiimide type resin. (B) The thermosetting resin may be used singly or in a combination of two or more of them.

It is preferable that (B) the thermosetting resin includes (B-1) an epoxy resin. (B-1) The epoxy resin represents the resin having one or more epoxy groups in one molecule thereof. When (B) the thermosetting resin includes (B-1) the epoxy resin, the dispersibility of (A) the Fe-Ni-Si type alloy magnetic powder can be enhanced, and the relative magnetic permeability and the magnetic loss of the cured product of the resin composition can be effectively improved.

Illustrative examples of (B-1) the epoxy resin may include a bixylenol type epoxy resin, a bisphenol A type epoxy resin; a bisphenol F type epoxy resin; a bisphenol S type epoxy resin; a bisphenol AF type epoxy resin; a dicyclopentadiene type epoxy resin; a trisphenol type epoxy resin; a phenol novolac type epoxy resin; a glycidylamine type epoxy resin; a glycidyl ester type epoxy resin; a cresol novolac type epoxy resin; a biphenyl type epoxy resin; a linear aliphatic epoxy resin; an epoxy resin containing a butadiene structure; an alicyclic epoxy resin; an alicyclic epoxy resin containing an ester skeleton; a heterocyclic epoxy resin; an epoxy resin containing a spiro ring; a cyclohexane type epoxy resin; a cyclohexane dimethanol type epoxy resin; a trimethylol type epoxy resin; a tetraphenylethane type epoxy resin; epoxy resins containing a condensed ring skeleton such as a naphthylene ether type epoxy resin, a tert-butyl-catechol type epoxy resin, a naphthalene type epoxy resin, a naphthol type epoxy resin, an anthracene type epoxy resin, and a naphthol novolac type epoxy resin; an isocyanurate type epoxy resin; an epoxy resin containing an alkyleneoxy skeleton and a butadiene skeleton; and an epoxy resin containing a fluorene structure. (B-1) The epoxy resin may be used singly or in a combination of two or more of them.

It is preferable that (B-1) the epoxy resin includes an epoxy resin having two or more epoxy groups in one molecule thereof. The ratio of the epoxy resin having two or more epoxy groups in one molecule thereof relative to 100% by mass of the total amount of (B-1) the epoxy resin is preferably 50% by mass or more, more preferably 60% by mass or more, and especially preferably 70% by mass or more.

It is preferable that (B-1) the epoxy resin contains an aromatic structure. When two or more epoxy resins are used, it is preferable that one or more of the epoxy resins contain the aromatic structure. The aromatic structure is the chemical structure that is generally defined as aromatic, including a polycyclic aromatic ring and an aromatic heterocycle.

In (B-1) the epoxy resin, there are an epoxy resin that is in the state of liquid at 20°C (hereinafter, this may be referred to as "liquid epoxy resin") and an epoxy resin that is in the state of solid at 20°C (hereinafter, this may be referred to as "solid epoxy resin"). (B-1) The epoxy resin may be only the liquid epoxy resin, or only the solid epoxy resin, or a combination of the liquid epoxy resin and the solid epoxy resin. Among them, (B-1) the epoxy resin preferably includes the liquid epoxy resin, and especially preferably includes only the liquid epoxy resin.

As for the liquid epoxy resin, the liquid epoxy resin having two or more epoxy groups in one molecule thereof is preferable. The liquid epoxy resin is preferably a bisphenol A type epoxy resin, a bisphenol F type epoxy resin, a bisphenol AF type epoxy resin, a naphthalene type epoxy resin, a glycidyl ester type epoxy resin, a glycidylamine type epoxy resin, a phenol novolac type epoxy resin, an alicyclic epoxy resin containing an ester skeleton, a cyclohexane type epoxy resin, a cyclohexane dimethanol type epoxy resin, an epoxy resin containing a butadiene structure, an epoxy resin containing an alkyleneoxy skeleton and a butadiene skeleton, an epoxy resin containing a fluorene structure, and a dicyclopentadiene type epoxy resin. Among them, a bisphenol A type epoxy resin and a bisphenol F type epoxy resin are especially preferable.

Specific examples of the liquid epoxy resin may include "YX7400" manufactured by Mitsubishi Chemical Corp.; "HP4032", "HP4032D", and "HP4032SS", manufactured by DIC Corp. (naphthalene type epoxy resin); "828US", "828EL", "jER828EL", "825", and "Epikote 828EL", manufactured by Mitsubishi Chemical Corp. (bisphenol A type epoxy resin); "jER807" and "1750", manufactured by Mitsubishi Chemical Corp. (bisphenol F type epoxy resin); "jER152" manufactured by Mitsubishi Chemical Corp. (phenol novolac type epoxy resin); "630", "630LSD", and "604", manufactured by Mitsubishi Chemical Corp. (glycidylamine type epoxy resin); "ED-523T" manufactured by Adeka Corp. (glycyrol type epoxy resin); "EP-3950L" and "EP-3980S", manufactured by Adeka Corp. (glycidylamine type epoxy resin); "EP-4088S" manufactured by Adeka Corp. (dicyclopentadiene type epoxy resin); "ZX-1059" manufactured by Nippon Steel Chemical & Material Co., Ltd. (mixture of bisphenol A type epoxy resin and bisphenol F type epoxy resin); "EX-721" manufactured by Nagase ChemteX Corp. (glycidyl ester type epoxy resin); "EX-991L" manufactured by Nagase ChemteX Corp. (epoxy resin containing an alkyleneoxy skeleton); "Celloxide 2021P" and "Celloxide 2081", manufactured by Daicel Corp. (alicyclic epoxy resin containing ester skeleton); "PB-3600" manufactured by Daicel Corp., "JP-100" and "JP-200", manufactured by Nippon Soda Co., Ltd. (epoxy resin containing butadiene skeleton); "ZX-1658" and "ZX-1658GS", manufactured by Nippon Steel Chemical & Material Co., Ltd. (liquid 1,4-glycidylcyclohexane type epoxy resin); and "EG-280" manufactured by Osaka Gas Chemicals Co., Ltd. (epoxy resin containing fluorene structure). The liquid epoxy resin may be used singly or in a combination of two or more of them.

As for the solid epoxy resin, the solid epoxy resin having three or more epoxy groups in one molecule thereof is preferable; the aromatic solid epoxy resin having three or more epoxy groups in one molecule thereof is more preferable. The solid epoxy resin is preferably a bixylenol type epoxy resin, a naphthalene type epoxy resin, a naphthalene type four-functional epoxy resin, a cresol novolac type epoxy resin, a dicyclopentadiene type epoxy resin, a trisphenol type epoxy resin, a naphthol type epoxy resin, a biphenyl type epoxy resin, a naphthylene ether type epoxy resin, an anthracene type epoxy resin, a bisphenol A type epoxy resin, a bisphenol AF type epoxy resin, or a tetraphenylethane type epoxy resin; among these, the dicyclopentadiene type epoxy resin is especially preferable.

Specific examples of the solid epoxy resin may include "HP4032H" manufactured by DIC Corp. (naphthalene type epoxy resin); "HP-4700" and "HP-4710" manufactured by DIC Corp. (naphthalene type four-functional epoxy resin); "N-690" manufactured by DIC Corp. (cresol novolac type epoxy resin); "N-695" manufactured by DIC Corp. (cresol novolac type epoxy resin); "HP-7200", "HP-7200HH", and "HP-7200H" manufactured by DIC Corp. (dicyclopentadiene type epoxy resin); "EXA-7311", "EXA-7311-G3", "EXA-7311-G4", "EXA-7311-G4S", and "HP6000" manufactured by DIC Corp. (naphthylene ether type epoxy resin); "EPPN-502H" manufactured by Nippon Kayaku Co., Ltd. (trisphenol type epoxy resin); "NC7000L" manufactured by Nippon Kayaku Co., Ltd. (naphthol novolac type epoxy resin); "NC3000H", "NC3000", "NC3000L", and "NC3100" manufactured by Nippon Kayaku Co., Ltd. (biphenyl type epoxy resin); "ESN475V" manufactured by Nippon Steel Chemical & Material Co., Ltd. (naphthol type epoxy resin); "ESN485" manufactured by Nippon Steel Chemical & Material Co., Ltd. (naphthol novolac type epoxy resin); "YX4000H", "YX4000", and "YL6121" manufactured by Mitsubishi Chemical Corp. (biphenyl type epoxy resin); "YX4000HK" manufactured by Mitsubishi Chemical Corp. (bixylenol type epoxy resin); "YX8800" manufactured by Mitsubishi Chemical Corp. (anthracene type epoxy resin); "YX7700" manufactured by Mitsubishi Chemical Corp. (novolac type epoxy resin containing a xylene structure); "PG-100" and "CG-500", manufactured by Osaka Gas Chemicals Co., Ltd.; "YL7760" manufactured by Mitsubishi Chemical Corp. (bisphenol AF type epoxy resin); "YL7800" manufactured by Mitsubishi Chemical Corp. (fluorene type epoxy resin); "jER1010" manufactured by Mitsubishi Chemical Corp. (solid bisphenol A type epoxy resin); and "jER1031S" manufactured by Mitsubishi Chemical Corp. (tetraphenylethane type epoxy resin). The solid epoxy resin may be used singly or in a combination of two or more of them.

When a combination of the liquid epoxy resin and the solid epoxy resin is used as the epoxy resin, the mass ratio (liquid epoxy resin/solid epoxy resin) of the liquid epoxy resin with respect to the solid epoxy resin is preferably 0.5 or more, more preferably 1 or more, still more preferably 5 or more, and especially preferably 10 or more.

The epoxy equivalent of (B-1) the epoxy resin is preferably 50 g/eq. to 5000 g/eq., more preferably 50 g/eq. to 3000 g/eq., still more preferably 80 g/eq. to 2000 g/eq., and far still more preferably 110 g/eq. to 1000 g/eq. The epoxy equivalent is the mass of the resin per one equivalent of the epoxy group. The epoxy equivalent can be measured by the method in accordance with JIS K7236.

The weight-average molecular weight (Mw) of (B-1) the epoxy resin is preferably 100 to 5000, more preferably 250 to 3000, and still more preferably 400 to 1500. The weight-average molecular weight of the resin can be measured in terms of polystyrene by a gel permeation chromatography (GPC) method.

The amount (% by mass) of (B-1) the epoxy resin included in the resin composition is preferably 0.1% by mass or more, more preferably 0.5% by mass or more, and especially preferably 1% by mass or more, and is preferably 30% by mass or less, more preferably 20% by mass or less, and especially preferably 10% by mass or less, relative to 100% by mass of the nonvolatile components in the resin composition. When the amount of (B-1) the epoxy resin is in the range described above, the relative magnetic permeability and the magnetic loss of the cured product of the resin composition can be effectively improved.

The amount (% by mass) of (B-1) the epoxy resin included in the resin composition is preferably 10% by mass or more, more preferably 20% by mass or more, and especially preferably 30% by mass or more, and is preferably 90% by mass or less, more preferably 80% by mass or less, and especially preferably 70% by mass or less, relative to 100% by mass of the resin component in the resin composition. When the amount of (B-1) the epoxy resin is in the range described above, the relative magnetic permeability and the magnetic loss of the cured product of the resin composition can be effectively improved.

When (B) the thermosetting resin includes (B-1) the epoxy resin, (B) the thermosetting resin may include a resin that is capable of undergoing the reaction with (B-1) the epoxy resin to form a bond. Hereinafter, the resin that is capable of undergoing the reaction with (B-1) the epoxy resin to form a bond may be referred to as (B-2) a "curing agent". Illustrative examples of (B-2) the curing agent may include a phenol type resin, an active ester type resin, an amine type resin, a carbodiimide type resin, an acid anhydride type resin, a benzoxazine type resin, a cyanate ester type resin, and a thiol type resin. (B-2) The curing agent may be used singly or in a combination of two or more of them. Among these, a phenol type resin is especially preferable.

As for the phenol type resin, a resin having one or more, preferably two or more, hydroxyl groups bonding to an aromatic ring such as a benzene ring or a naphthalene ring in one molecule thereof may be used. In view of the heat resistance and the water resistance, a phenol type resin having a novolac structure is preferable. In view of the adhesion property, a nitrogen-containing phenol type resin is preferable, and a phenol type resin containing a triazine skeleton is more preferable. In particular, from the viewpoint of highly satisfying a heat resistance, a water resistance, and an adhesion property, a phenol novolac resin containing a triazine skeleton is preferable.

Specific examples of the phenol type resin may include "MEH-7700", "MEH-7810", "MEH-7851", and "MEH-8000H", manufactured by Meiwa Plastic Industries, Ltd.; "NHN", "CBN", and "GPH", manufactured by Nippon Kayaku Co., Ltd.; "SN-170", "SN-180", "SN-190", "SN-475", "SN-485", "SN-495", "SN-495V", "SN-375", and "SN-395", manufactured by Nippon Steel Chemical & Material Co., Ltd.; "TD-2090", "TD-2090-60M", "LA-7052", "LA-7054", "LA-1356", "LA-3018", "LA-3018-50P", "EXB-9500", "HPC-9500", "KA-1160", "KA-1163", and "KA-1165", manufactured by DIC Corp.; and "GDP-6115L", "GDP-6115H", and "ELPC75", manufactured by Gunei Chemical Industry Co., Ltd.

As for the active ester type resin, a compound having one or more, and preferably two or more active ester groups in one molecule thereof may be used. Among the active ester type resins, the compound having two or more highly reactive ester groups in one molecule thereof are preferable as the active ester type resin, such as a phenol ester type compound, a thiophenol ester type compound, an N-hydroxylamine ester type compound, and an ester compound of a heterocyclic hydroxy compound. The active ester type resin is preferably the compound that is obtained by condensation reaction of a carboxylic acid compound and/or a thiocarboxylic acid compound with a hydroxy compound and/or a thiol compound. Especially, from the viewpoint of improvement in a heat resistance, an active ester type resin obtained from a carboxylic acid compound and a hydroxy compound is preferable, while an active ester type resin obtained from a carboxylic acid compound and a phenol compound and/or a naphthol compound is more preferable. Illustrative examples of the carboxylic acid compound may include benzoic acid, acetic acid, succinic acid, maleic acid, itaconic acid, phthalic acid, isophthalic acid, terephthalic acid, and pyromellitic acid. Illustrative examples of the phenol compound or the naphthol compound may include hydroquinone, resorcin, bisphenol A, bisphenol F, bisphenol S, phenolphthalin, methylated bisphenol A, methylated bisphenol F, methylated bisphenol S, phenol, o-cresol, m-cresol, p-cresol, catechol, α-naphthol, β-naphthol, 1,5-dihydroxy naphthalene, 1,6-dihydroxy naphthalene, 2,6-dihydroxy naphthalene, dihydroxy benzophenone, trihydroxy benzophenone, tetrahydroxy benzophenone, phloroglucin, benzene triol, a dicyclopentadiene type diphenol compound, and phenol novolac. Here, the "dicyclopentadiene type diphenol compound" means a diphenol compound obtained by condensation of one dicyclopentadiene molecule with two phenol molecules.

Specific examples of the preferable active ester type resin may include an active ester type resin containing a dicyclopentadiene type diphenol structure, an active ester type resin containing a naphthalene structure, an active ester type resin containing an acetylated phenol novolac, and an active ester type resin containing a benzoylated phenol novolac. Among them, the active ester type resin containing a naphthalene structure and the active ester type resin containing a dicyclopentadiene type diphenol structure are more preferable. Here, the "dicyclopentadiene type diphenol structure" means the divalent structure unit formed of phenylene-dicyclopentylene-phenylene.

Illustrative examples of the commercially available active ester type resin may include active ester type resins containing a dicyclopentadiene type diphenol structure, such as "EXB9451", "EXB9460", "EXB9460S", "HPC-8000-65T", "HPC-8000H-65TM", and "EXB-8000L-65TM" (manufactured by DIC Corp.); active ester type resins containing a naphthalene structure, such as "EXB-9416-70BK", "EXB-8150-65T", "EXB-8100L-65T", and "EXB-8150L-65T" (manufactured by DIC Corp.); active ester type resins containing an acetylated phenol novolac, such as "DC808" (manufactured by Mitsubishi Chemical Corp.); active ester type resins containing a benzoylated phenol novolac, such as "YLH1026" (manufactured by Mitsubishi Chemical Corp.); active ester type resins as the acetylated phenol novolac, such as "DC808" (manufactured by Mitsubishi Chemical Corp.); and active ester type resins as the benzoylated phenol novolac, such as "YLH1026" (manufactured by Mitsubishi Chemical Corp.), "YLH1030" (manufactured by Mitsubishi Chemical Corp.), and "YLH1048" (manufactured by Mitsubishi Chemical Corp.).

As for the amine type resin, a resin having one or more, and preferably two or more amino groups in one molecule thereof may be used. Illustrative examples of the amine type resin may include an aliphatic amine compound, a polyether amine compound, an alicyclic amine compound, and an aromatic amine compound. Among them, an aromatic amine compound is preferable. The amine type resin is preferably a primary amine or a secondary amine; a primary amine is more preferable. Specific examples of the amine type resin may include 4,4'-methylenebis(2,6-dimethylaniline), diphenyl diaminosulfone, 4,4'-diaminodiphenylmethane, 4,4'-diaminodiphenyl sulfone, 3,3'-diaminodiphenyl sulfone, m-phenylenediamine, m-xylylenediamine, diethyltoluenediamine, 4,4'-diaminodiphenyl ether, 3,3'-dimethyl-4,4'-diaminobiphenyl, 2,2'-dimethyl-4,4'-diaminobiphenyl, 3,3'-dihydroxybenzidine, 2,2-bis(3-amino-4-hydroxyphenyl)propane, 3,3-dimethyl-5,5-diethyl-4,4-diphenylmethanediamine, 2,2-bis(4-aminophenyl)propane, 2,2-bis(4-(4-aminophenoxy)phenyl)propane, 1,3-bis(3-aminophenoxy)benzene, 1,3-bis(4-aminophenoxy)benzene, 1,4-bis(4-aminophenoxy)benzene, 4,4'-bis(4-aminophenoxy)biphenyl, bis(4-(4-aminophenoxy)phenyl) sulfone, and bis(4-(3-aminophenoxy)phenyl) sulfone. Commercially available amine type resins may be used. Illustrative examples thereof may include "KAYABOND C-200S", "KAYABOND C-100", "KAYAHARD A-A", "KAYAHARD A-B", and "KAYAHARD A-S", manufactured by Nippon Kayaku Co. Ltd., as well as "Epicure W" manufactured by Mitsubishi Chemical Corp.

As for the carbodiimide type resin, a resin having one or more, and preferably two or more carbodiimide structures in one molecule thereof may be used. Specific examples of the carbodiimide type resin may include biscarbodiimides including aliphatic biscarbodiimides such as tetramethylene-bis(t-butylcarbodiimide) and cyclohexanebis(methylene-t-butylcarbodiimide), and aromatic biscarbodiimides such as phenylene-bis(xylylcarbodiimide); and polycarbodiimides including aliphatic polycarbodiimides such as polyhexamethylene carbodiimide, polytrimethylhexamethylene carbodiimide, polycyclohexylene carbodiimide, poly(methylenebiscyclohexylene carbodiimide), and poly(isophorone carbodiimide), and aromatic polycarbodiimides such as poly(phenylene carbodiimide), poly(naphthylene carbodiimide), poly(tolylene carbodiimide), poly(methyldiisopropylphenylene carbodiimide), poly(triethylphenylene carbodiimide), poly(diethylphenylene carbodiimide), poly(triisopropylphenylene carbodiimide), poly(diisopropylphenylene carbodiimide), poly(xylylene carbodiimide), poly(tetramethylxylylene carbodiimide), poly(methylenediphenylene carbodiimide), and poly[methylenebis(methylphenylene) carbodiimide]. Illustrative examples of the commercially available carbodiimide type resin may include "Carbodilite V-02B", "Carbodilite V-03", "Carbodilite V-04K", "Carbodilite V-07", and "Carbodilite V-09", manufactured by Nisshinbo Chemical Inc.; and "Stabaxol P", "Stabaxol P400", and "Hycasyl 510", manufactured by Rhein Chemie GmbH.

As for the acid anhydride type resin, a resin that has one or more acid anhydride groups in one molecule thereof may be used, in which the resin having two or more acid anhydride groups in one molecule thereof is preferable. Specific examples of the acid anhydride type resin may include phthalic anhydride, tetrahydrophthalic anhydride, hexahydrophthalic anhydride, methyl tetrahydrophthalic anhydride, methyl hexahydrophthalic anhydride, methylnadic anhydride, hydrogenated methylnadic anhydride, trialkyl tetrahydrophthalic anhydride, dodecenyl succinic anhydride, 5-(2,5-dioxotetrahydro-3-furanyl)-3-methyl-3-cyclohexene-1,2-dicarboxylic anhydride, trimellitic anhydride, pyromellitic anhydride, benzophenone tetracarboxylic dianhydride, biphenyl tetracarboxylic dianhydride, naphthalene tetracarboxylic dianhydride, oxydiphthalic dianhydride, 3,3'-4,4'-diphenylsulfone tetracarboxylic dianhydride, 1,3,3a,4,5,9b-hexahydro-5-(tetrahydro-2,5-dioxo-3-furanyl)-naphto[1,2-C]furan-1,3-dione, ethylene glycol bis(anhydrotrimellitate), and a polymer type acid anhydride such as a styrene-maleic acid resin, which is a copolymer of styrene and maleic acid. Illustrative examples of the commercially available product of the acid anhydride type resin may include "HNA-100", "MH-700", "MTA-15", "DDSA", and "OSA", manufactured by New Japan Chemical Co., Ltd.; "YH-306" and "YH-307", manufactured by Mitsubishi Chemical Corp.; "HN-2200" and "HN-5500", manufactured by Hitachi Chemical Co., Ltd.; and "EF-30", "EF-40, "EF-60", and "EF-80", manufactured by Cray Valley S.A.

Specific examples of the benzoxazine type resin may include "JBZ-OD100", "JBZ-OP100D", and "ODA-BOZ", manufactured by JFE Chemical Corp.; "P-d" and "F-a", manufactured by Shikoku Chemicals Corp.; and "HFB2006M" manufactured by Showa Highpolymer Co., Ltd.

Illustrative examples of the cyanate ester type resin may include bifunctional cyanate resins such as bisphenol A dicyanate, polyphenol cyanate, oligo(3-methylene-1,5-phenylenecyanate), 4,4'-methylenebis(2,6-dimethylphenylcyanate), 4,4'-ethylidene diphenyl dicyanate, hexafluorobisphenol A dicyanate, 2,2-bis(4-cyanate)phenylpropane, 1,1-bis(4-cyanatephenylmethane), bis(4-cyanate-3,5-dimethylphenyl)methane, 1,3-bis(4-cyanatephenyl-1-(methylethylidene))benzene, bis(4-cyanatephenyl) thioether, and bis(4-cyanatephenyl) ether; polyfunctional cyanate resins derived from a phenol novolac, a cresol novolac, and the like; and a prepolymer in which these cyanate resins partially form triazine. Specific examples of the cyanate ester type resin may include "PT30" and "PT60", (phenol novolac type polyfunctional cyanate ester resin); "ULL-950S" (polyfunctional cyanate ester); "BA230" and "BA230S75" (prepolymers in which part or all of bisphenol A dicyanate form triazine so as to be a trimer), manufactured all by Lonza Japan Ltd.

Illustrative examples of the thiol type resin may include trimethylolpropane tris(3-mercaptopropionate), pentaerythritol tetrakis(3-mercaptobutyrate), and tris(3-mercaptopropyl) isocyanurate.

The active group equivalent of (B-2) the curing agent is preferably 50 g/eq. to 3000 g/eq., more preferably 100 g/eq. to 1000 g/eq., still more preferably 100 g/eq. to 500 g/eq., and especially preferably 100 g/eq. to 300 g/eq. The active group equivalent represents the mass of (B-2) the curing agent per one equivalent of the active group.

The number of the active groups in (B-2) the curing agent relative to one epoxy group in (B-1) the epoxy resin is preferably 0.01 or more, more preferably 0.1 or more, and especially preferably 0.5 or more, and is preferably 10 or less, more preferably 5 or less, and especially preferably 3 or less. The active group in (B-2) the curing agent is, for example, an active hydroxy group and the like; they are different depending on kinds of the curing agent. The number of the epoxy groups in (B-1) the epoxy resin is the total value obtained by dividing the mass of the nonvolatile components in each epoxy resin with the epoxy equivalent and adding the divided values for all the epoxy resins. The number of the active groups in (B-2) the curing agent is the total value obtained by dividing the mass of the nonvolatile components in each curing agent with the active group equivalent and adding the divided values for all the curing agents.

The amount (% by mass) of (B-2) the curing agent included in the resin composition is preferably 0.1% by mass or more, more preferably 0.5% by mass or more, and especially preferably 1% by mass or more, and is preferably 20% by mass or less, more preferably 10% by mass or less, and especially preferably 5% by mass or less, relative to 100% by mass of the nonvolatile components in the resin composition. When the amount of (B-2) the curing agent is within the range described above, the relative magnetic permeability and the magnetic loss of the cured product of the resin composition can be effectively improved.

The amount (% by mass) of (B-2) the curing agent included in the resin composition is preferably 1% by mass or more, more preferably 5% by mass or more, and especially preferably 10% by mass or more, and is preferably 50% by mass or less, more preferably 40% by mass or less, and especially preferably 30% by mass or less, relative to 100% by mass of the resin component in the resin composition. When the amount of (B-2) the curing agent is within the range described above, the relative magnetic permeability and the magnetic loss of the cured product of the resin composition can be effectively improved.

The weight-average molecular weight (Mw) of (B) the thermosetting resin may be in the same range as that of the weight-average molecular weight of (B-1) the epoxy resin.

The amount (% by mass) of (B) the thermosetting resin included in the resin composition is preferably 0.1% by mass or more, more preferably 0.5% by mass or more, and especially preferably 1% by mass or more, and is preferably 30% by mass or less, more preferably 20% by mass or less, and especially preferably 10% by mass or less, relative to 100% by mass of the nonvolatile components in the resin composition. When the amount of (B) the thermosetting resin is within the range described above, the relative magnetic permeability and the magnetic loss of the cured product of the resin composition can be effectively improved.

The amount (% by mass) of (B) the thermosetting resin included in the resin composition is preferably 10% by mass or more, more preferably 30% by mass or more, and especially preferably 50% by mass or more, and is preferably 99% by mass or less, more preferably 90% by mass or less, and especially preferably 80% by mass or less, relative to 100% by mass of the resin component in the resin composition. When the amount of (B) the thermosetting resin is within the range described above, the relative magnetic permeability and the magnetic loss of the cured product of the resin composition can be effectively improved.

### <(C) Optional Magnetic Powder (Magnetic Powder Other Than Fe-Ni-Si Type Alloy Magnetic Powder)>

The resin composition according to one embodiment of the present invention may further include (C) a magnetic powder other than the Fe-Ni-Si type alloy magnetic powder as an optional component in combination with the (A) and (B) components described above. "(C) The magnetic powder other than Fe-Ni-Si type alloy magnetic powder" as this (C) component may be referred to as "(C) optional magnetic powder" as appropriate.

As for (C) the optional magnetic powder, a particle of the material having the relative magnetic permeability of more than 1 may be used. In general, the material of (C) the optional magnetic powder is an inorganic material, and this may be any of a soft magnetic material and a hard magnetic material. The material of (C) the optional magnetic powder may be used singly or in a combination of two or more of them. Therefore, (C) the optional magnetic powder may be any of a soft magnetic powder, a hard magnetic powder, and a combination of the soft magnetic powder and the hard magnetic powder. (C) The optional magnetic powder may be used singly or as a combination of two or more of them. In particular, (C) the optional magnetic powder preferably includes a soft magnetic powder, and more preferably includes only the soft magnetic powder.

Illustrative examples of (C) the optional magnetic powder may include a magnetic metal oxide powder and a magnetic metal powder.

Illustrative examples of the magnetic metal oxide powder may include a ferrite type magnetic powder; and iron oxide powders such as an iron oxide powder (III) and a triiron tetroxide powder. Among these, a ferrite type magnetic powder is preferable. Therefore, it is preferable that (C) the optional magnetic powder includes a ferrite type magnetic powder. In one example, as for (C) the optional magnetic powder, only a ferrite type magnetic powder may be used. Usually, the ferrite type magnetic powder is composed of a composite oxide including an iron oxide as the main component thereof, and is chemically stable. Therefore, the ferrite type magnetic powder offers advantages such as a high corrosion resistance, a low risk of ignition, and a resistance to demagnetization.

Illustrative examples of the ferrite type magnetic powder may include a Fe-Mn type ferrite powder, a Fe-Mn-Mg type ferrite powder, a Fe-Mn-Mg-Sr type ferrite powder, a Fe-Mg-Zn type ferrite powder, a Fe-Mg-Sr type ferrite powder, a Fe-Zn-Mn type ferrite powder, a Fe-Cu-Zn type ferrite powder, a Fe-Ni-Zn type ferrite powder, a Fe-Ni-Zn-Cu type ferrite powder, a Fe-Ba-Zn type ferrite powder, a Fe-Ba-Mg type ferrite powder, a Fe-Ba-Ni type ferrite powder, a Fe-Ba-Co type ferrite powder, a Fe-Ba-Ni-Co type ferrite powder, and a Fe-Y type ferrite powder.

Among the ferrite type magnetic powders, a ferrite type magnetic powder containing at least one element selected from the group consisting of Mn, Zn, Ni, and Cu is preferable. Therefore, it is preferable that (C) the optional magnetic powder includes a ferrite type magnetic powder containing at least one element selected from the group consisting of Mn, Zn, Ni, and Cu. In one example, only a ferrite type magnetic powder containing at least one element selected from the group consisting of Mn, Zn, Ni, and Cu may be used as (C) the optional magnetic powder. Illustrative examples of the preferable ferrite type magnetic powder may include a Fe-Mn type ferrite powder, a Fe-Mn-Mg type ferrite powder, a Fe-Mn-Mg-Sr type ferrite powder, a Fe-Mg-Zn type ferrite powder, a Fe-Zn-Mn type ferrite powder, a Fe-Cu-Zn type ferrite powder, a Fe-Ni-Zn type ferrite powder, a Fe-Ni-Zn-Cu type ferrite powder, a Fe-Ba-Zn type ferrite powder, a Fe-Ba-Ni type ferrite powder, and a Fe-Ba-Ni-Co type ferrite powder. Among these, a ferrite type magnetic powder containing at least one element selected from the group consisting of Zn and Mn is more preferable, and a ferrite type magnetic powder containing Zn and Mn is especially preferable. Therefore, a Fe-Zn-Mn type ferrite powder is especially preferable as the ferrite type magnetic powder. The Fe-Zn-Mn type ferrite powder represents the ferrite powder containing Fe, Zn, and Mn.

Illustrative examples of the magnetic metal powder may include a pure iron powder; and crystalline or non-crystalline alloy magnetic powders such as a Fe-Si type alloy powder, a Fe-Si-Al type alloy powder, a Fe-Cr type alloy powder, a Fe-Cr-Si type alloy powder, a Fe-Ni-Cr type alloy powder, a Fe-Cr-Al type alloy powder, a Fe-Ni type alloy powder, a Fe-Ni-B type alloy powder, a Fe-Ni-Mo type alloy powder, a Fe-Ni-Mo-Cu type alloy powder, a Fe-Co type alloy powder, a Fe-Ni-Co type alloy powder, and a Co-based amorphous alloy powder. Among these, alloy magnetic powders other than the Fe-Ni-Si type alloy magnetic powder are preferable. Therefore, it is preferable that (C) the optional magnetic powder includes an alloy magnetic powder other than the Fe-Ni-Si type alloy magnetic powder. In one example, only an alloy magnetic powder other than the Fe-Ni-Si type alloy magnetic powder may be used as (C) the optional magnetic powder. Among the alloy magnetic powders, an iron alloy type powder is more preferable.

In particular, as for the preferable magnetic metal powder, an iron alloy type magnetic powder containing Fe, as well as at least one element selected from the group consisting of Si and Cr is preferable; and a Fe-Cr-Si type alloy powder is especially preferable. The Fe-Cr-Si type alloy powder represents the alloy powder containing Fe, Cr, and Si.

As for (C) the optional magnetic powder, commercially available magnetic powders may be used. Specific examples of the commercially available magnetic powder may include "MZ03S", "M05S", "M001", and "MZ05S", manufactured by Powdertech Co., Ltd.; "PST-S" manufactured by Sanyo Special Steel Co., Ltd.; "AW2-08", "AW2-08PF20F", "AW2-08PF10F", "AW2-08PF3F", "Fe-3.5Si-4.5CrPF20F", "Fe-50NiPF20F", and "Fe-80Ni-4MoPF20F", manufactured by Epson Atmix Corp.; "CVD iron powder 0.7 µm", "LD-M", "LD-MH", "KNI-106", "KNI-106GSM", "KNI-106GS", "KNI-109", "KNI-109GSM", and "KNI-109GS", manufactured by JFE Chemical Corp.; "KNS-415", "BSF-547", "BSF-029", "BSN-125", "BSN-125", "BSN-714", "BSN-828", "S-1281", "S-1641", "S-1651", "S-1470", "S-1511", and "S-2430", manufactured by Toda Kogyo Corp.; "JR09P2" manufactured by Japan Metals and Chemicals Co., Ltd.; "Nanotek" manufactured by CIK-NanoTek Corp.; "JEMK-S" and "JEMK-H", manufactured by Kinsei Matec Co., Ltd.; "Yttrium Iron Oxide" manufactured by Aldrich Corp.; and "MA-RCO-5" manufactured by Dowa Electronics Materials Co., Ltd. (C) The optional magnetic powder may be used singly or in a combination of two or more of them.

It is preferable that (C) the optional magnetic powder has a smaller average particle diameter than (A) the Fe-Ni-Si type alloy magnetic powder. When (C) the optional magnetic powder has a smaller average particle diameter than (A) the Fe-Ni-Si type alloy magnetic powder, it is possible for (C) the optional magnetic powder to enter the gaps between the particles of (A) the Fe-Ni-Si type alloy magnetic powder; thus, this enables high filling of the magnetic powders, resulting in improvement of the magnetic properties such as the relative magnetic permeability.

It is preferable that the ratio (average particle diameter of (C) the optional magnetic powder / average particle diameter of (A) the Fe-Ni-Si type alloy magnetic powder) of the average particle diameter of (C) the optional magnetic powder with respect to the average particle diameter of (A) the Fe-Ni-Si type alloy magnetic powder is in a particular range. Specifically, the ratio (average particle diameter of (C) the optional magnetic powder / average particle diameter of (A) the Fe-Ni-Si type alloy magnetic powder) is preferably 0.001 or more, more preferably 0.01 or more, and especially preferably 0.1 or more, and is preferably 0.9 or less, more preferably 0.6 or less, and especially preferably 0.3 or less. When the ratio (average particle diameter of (C) the optional magnetic powder / average particle diameter of (A) the Fe-Ni-Si type alloy magnetic powder) is within the range described above, the relative magnetic permeability and the magnetic loss of the cured product of the resin composition can be effectively improved.

The specific range of the average particle diameter of (C) the optional magnetic powder is preferably 0.05 µm or more, more preferably 0.1 µm or more, and especially preferably 0.2 µm or more, and is preferably 3 µm or less, more preferably 2 µm or less, and especially preferably 1.5 µm or less. When the average particle diameter of (C) the optional magnetic powder is equal to or more than the lower limit described above, the viscosity of the resin composition can be lowered. When the average particle diameter thereof is equal to or less than the upper limit, the relative magnetic permeability and the magnetic loss of the cured product of the resin composition can be effectively improved.

The average particle diameter of (C) the optional magnetic powder can be measured by the same method as the average particle diameter of (A) the Fe-Ni-Si type alloy magnetic powder.

The specific surface area of (C) the optional magnetic powder is preferably larger than the specific surface area of (A) the Fe-Ni-Si type alloy magnetic powder. The specific range of the specific surface area of (C) the optional magnetic powder is preferably 0.1 m²/g or more, more preferably 1.0 m²/g or more, and especially preferably 2 m²/g or more, and is preferably 40 m²/g or less, more preferably 30 m²/g or less, and especially preferably 20 m²/g or less.

The particle of (C) the optional magnetic powder is preferably spherical or ellipsoidal. The ratio (aspect ratio) that is obtained by dividing the length of the longitude axis by the length of the short axis of the particle of (C) the optional magnetic powder is preferably 2 or less, more preferably 1.5 or less, and still more preferably 1.2 or less. This is usually 1.0 or more. In general, when the particle shape of the magnetic powder is not spherical but flat, the relative magnetic permeability can be increased readily. On the other hand, when the particle shape of the magnetic powder is close to spherical, the magnetic loss can be decreased readily.

The true specific gravity of (C) the optional magnetic powder may be, for example, 4 g/cm³ to 10 g/cm³.

The amount (% by volume) of (C) the optional magnetic powder included in the resin composition may be 0% by volume, or more than 0% by volume, and is preferably 1% by volume or more, more preferably 5% by volume or more, especially preferably 10% by volume or more, preferably 40% by volume or less, more preferably 35% by volume or less, and especially preferably 30% by volume or less, relative to 100% by volume of the nonvolatile components in the resin composition. When the amount (% by volume) of (C) the optional magnetic powder is within the range described above, the relative magnetic permeability and the magnetic loss of the cured product of the resin composition can be effectively improved.

The amount (% by mass) of (C) the optional magnetic powder included in the resin composition may be 0% by mass, or more than 0% by mass, and is preferably 1% by mass or more, more preferably 5% by mass or more, especially preferably 10% by mass or more, preferably 40% by mass or less, more preferably 35% by mass or less, and especially preferably 30% by mass or less, relative to 100% by mass of the nonvolatile components in the resin composition. When the amount (% by mass) of (C) the optional magnetic powder is within the range described above, the relative magnetic permeability and the magnetic loss of the cured product of the resin composition can be effectively improved.

When (A) the Fe-Ni-Si type alloy magnetic powder and (C) the optional magnetic powder are used in combination, it is preferable that the volume ratio (component (C) / component (A)) of (C) the optional magnetic powder with respect to (A) the Fe-Ni-Si type alloy magnetic powder is in a particular range. Specifically, the volume ratio (component (C) / component (A)) is preferably 0.01 or more, more preferably 0.1 or more, still more preferably 0.2 or more, and especially preferably 0.3 or more, and is preferably 0.9 or less, more preferably 0.8 or less, and especially preferably 0.7 or less. When the volume ratio (component (C) / component (A)) is within the range described above, the relative magnetic permeability and the magnetic loss of the cured product of the resin composition can be effectively improved.

When (A) the Fe-Ni-Si type alloy magnetic powder and (C) the optional magnetic powder are used in combination, it is preferable that the mass ratio (component (C) / component (A)) of (C) the optional magnetic powder with respect to (A) the Fe-Ni-Si type alloy magnetic powder is within a particular range. Specifically, the mass ratio (component (C) / component (A)) is preferably 0.1 or more, more preferably 0.2 or more, and especially preferably 0.3 or more, and is preferably 0.7 or less, more preferably 0.6 or less, and especially preferably 0.5 or less. When the mass ratio (component (C) / component (A)) is within the range described above, the relative magnetic permeability and the magnetic loss of the cured product of the resin composition can be effectively improved.

### <(D) Thermoplastic Resin>

The resin composition according to one embodiment of the present invention may further include (D) a thermoplastic resin as the optional component in combination with the (A) to (C) components described above. (D) The thermoplastic resin as the (D) component does not include those that fall under the (A) to (C) components described above. When using (D) the thermoplastic resin, mechanical properties of the cured product of the resin composition can be effectively improved.

Illustrative examples of (D) the thermoplastic resin may include a phenoxy resin, a polyimide resin, a polyvinyl acetal resin, a polyolefin resin, a polybutadiene resin, a polyamide imide resin, a polyether imide resin, a polysulfone resin, a polyether sulfone resin, a polyphenylene ether resin, a polycarbonate resin, a polyether ether ketone resin, and a polyester resin. (D) The thermoplastic resin may be used singly or as a combination of two or more of them.

Illustrative examples of the phenoxy resin may include phenoxy resins containing one or more skeletons selected from the group consisting of a bisphenol A skeleton, a bisphenol F skeleton, a bisphenol S skeleton, a bisphenol acetophenone skeleton, a novolac skeleton, a biphenyl skeleton, a fluorene skeleton, a dicyclopentadiene skeleton, a norbornene skeleton, a naphthalene skeleton, an anthracene skeleton, an adamantane skeleton, a terpene skeleton, and a trimethylcyclohexane skeleton. The phenoxy resin may be terminated with any functional group such as a phenolic hydroxyl group or an epoxy group. Specific examples of the phenoxy resin may include "1256" and "4250" (both phenoxy resins containing a bisphenol A skeleton) manufactured by Mitsubishi Chemical Corp.; "YX8100" (phenoxy resin containing a bisphenol S skeleton) manufactured by Mitsubishi Chemical Corp.; "YX6954" (phenoxy resin containing a bisphenol acetophenone skeleton) manufactured by Mitsubishi Chemical Corp.; "FX280" and "FX293" manufactured by Nippon Steel Chemical & Material Co., Ltd.; and "YL7500BH30", "YX6954BH30", "YX7553", "YX7553BH30", "YL7769BH30", "YL6794", "YL7213", "YL7290", "YL7482", and "YL7891BH30", all being manufactured by Mitsubishi Chemical Corp.

Specific examples of the polyimide resin may include "SLK-6100" manufactured by Shin-Etsu Chemical Co., Ltd., and "Rikacoat SN20" and "Rikacoat PN20", both being manufactured by New Japan Chemical Co., Ltd. In addition, specific examples of the polyimide resin may include a linear polyimide that is obtained by reacting a bifunctional hydroxyl group-terminated polybutadiene, a diisocyanate compound, and a tetrabasic acid anhydride (polyimide described in Japanese Patent Application Laid-open No. 2006-37083), and modified polyimides such as the polyimides containing a polysiloxane skeleton (polyimides described in Japanese Patent Application Laid-open No. 2002-12667 and Japanese Patent Application Laid-open No. 2000-319386).

Illustrative examples of the polyvinyl acetal resin may include a polyvinylformal resin and a polyvinyl butyral resin; here, the polyvinyl butyral resin is preferable. Specific examples of the polyvinyl acetal resin may include "Denka Butyral 4000-2", "Denka Butyral 5000-A", "Denka Butyral 6000-C", and "Denka Butyral 6000-EP", all of them being manufactured by Denka Company Limited; and the S-LEC BH series, the BX series (e.g., BX-5Z), the KS series (e.g., KS-1), the BL series, and the BM series, all of them being manufactured by Sekisui Chemical Co., Ltd.

Illustrative examples of the polyolefin resin may include a low-density polyethylene, an ultra-low-density polyethylene, a high-density polyethylene, ethylene type copolymer resins such as an ethylene-vinyl acetate copolymer, an ethylene-ethyl acrylate copolymer, and an ethylene-methyl acrylate copolymer; and polyolefin polymers such as a polypropylene and an ethylene-propylene block copolymer.

Illustrative examples of the polybutadiene resin may include a resin containing a hydrogenated polybutadiene skeleton, a polybutadiene resin containing a hydroxy group, a polybutadiene resin containing a phenolic hydroxyl group, a polybutadiene resin containing a carboxy group, a polybutadiene resin containing an acid anhydride group, a polybutadiene resin containing an epoxy group, a polybutadiene resin containing an isocyanate group, a polybutadiene resin containing a urethane group, and a polyphenylene ether-polybutadiene resin.

Specific examples of the polyamide-imide resin may include "Vylomax HR11NN" and "Vylomax HR16NN", manufactured by Toyobo Co., Ltd. In addition, specific examples of the polyamide imide resin may include modified polyamide imides such as "KS9100" and "KS9300" (polyamide imide containing a polysiloxane skeleton), manufactured by Hitachi Chemical Co., Ltd.

Specific examples of the polyethersulfone resin may include "PES5003P" manufactured by Sumitomo Chemical Co., Ltd.

Specific examples of the polysulfone resin may include polysulfone "P1700" and "P3500", manufactured by Solvay Advanced Polymers, Inc.

Specific examples of the polyphenylene ether resin may include "NORYL SA90" manufactured by SABIC. Specific examples of the polyether imide resin may include "Ultem" manufactured by GE Company.

Illustrative examples of the polycarbonate resin may include a hydroxy group-containing carbonate resin, a phenolic hydroxy group-containing carbonate resin, a carboxy group-containing carbonate resin, an acid anhydride group-containing carbonate resin, an isocyanate group-containing carbonate resin, and a urethane group-containing carbonate resin. Specific examples of the polycarbonate resin may include "FPC0220" manufactured by Mitsubishi Gas Chemical Co. Ltd., "T6002" and "T6001" (polycarbonate diol), manufactured by Asahi Kasei Chemicals; and "C-1090", "C-2090", and "C-3090" (polycarbonate diol), manufactured by Kuraray Co., Ltd. Specific examples of the polyether ether ketone resin may include "Sumiploy K" manufactured by Sumitomo Chemical Co., Ltd.

Illustrative examples of the polyester resin may include a polyethylene terephthalate resin, a polyethylene naphthalate resin, a polybutylene terephthalate resin, a polybutylene naphthalate resin, a polytrimethylene terephthalate resin, a polytrimethylene naphthalate resin, and a polycyclohexanedimethyl terephthalate resin.

The weight-average molecular weight (Mw) of (D) the thermoplastic resin is preferably more than 5,000, more preferably 8,000 or more, still more preferably 10,000 or more, and especially preferably 20,000 or more. There is no particular restriction in the upper limit thereof; the upper limit may be, for example, 1,000,000 or less, 500,000 or less, or 100,000 or less.

The amount (% by mass) of (D) the thermoplastic resin included in the resin composition may be 0% by mass, or more than 0% by mass, and is preferably 0.01% by mass or more, more preferably 0.05% by mass or more, especially preferably 0.1% by mass or more, preferably 5% by mass or less, more preferably 3% by mass or less, and especially preferably 2% by mass or less, relative to 100% by mass of the nonvolatile components in the resin composition. When the amount of (D) the thermoplastic resin is within the range described above, the relative magnetic permeability and the magnetic loss of the cured product of the resin composition can be effectively improved.

The amount (% by mass) of (D) the thermoplastic resin included in the resin composition may be 0% by mass, or more than 0% by mass, and is preferably 1% by mass or more, more preferably 5% by mass or more, especially preferably 10% by mass or more, preferably 40% by mass or less, more preferably 30% by mass or less, and especially preferably 20% by mass or less, relative to 100% by mass of the resin components in the resin composition. When the amount of (D) the thermoplastic resin is within the range described above, the relative magnetic permeability and the magnetic loss of the cured product of the resin composition can be effectively improved.

### <(E) Dispersant>

The resin composition according to one embodiment of the present invention may further include (E) a dispersant as the optional component in combination with the (A) to (D) components described above. (E) The dispersant as the (E) component does not include those that fall under the (A) to (D) components described above. When using (E) the dispersant, the dispersibility of the magnetic powder such as (A) the Fe-Ni-Si type alloy magnetic powder and (C) the optional magnetic powder can be enhanced.

There is no restriction in the type of (E) the dispersant. Example of (E) the dispersant that can be used may include a dispersant that contains a functional group having an adsorption ability to the magnetic powder and that disperses the magnetic powder by repulsion (for example, electrostatic repulsion and steric repulsion,) among (E) the dispersants when the dispersant adsorbs onto the magnetic powder. Illustrative examples of (E) the dispersant may include an acidic dispersant and a basic dispersant.

The acidic dispersant usually contains an acidic functional group such as a carboxyl group, a sulfo group (-SO₃H), a sulfate group (-OSO₃H), a phosphono group (-PO(OH)₂), a phosphonooxy group (-OPO(OH)₂), a hydroxyphosphoryl group (-PO(OH)-), and a sulfanyl group (-SH). The acidic functional group usually has a dissociative proton and may be neutralized by a base such as an amine and a hydroxide ion. Preferable examples of the acidic dispersant may include an acidic polymer dispersant containing a polymer chain such as a polyoxyalkylene chain or a polyether chain. Preferable examples of the acidic dispersant may include "C-2093I" and "SC-1015F" (multifunctional comb-type functional polymer having an ionic group in the main chain and a polyoxyalkylene chain in the graft chain), manufactured by NOF Corp.; "ED152", "ED153", "ED154", "ED118", "ED174", "ED251", and "DA-375" (polyether type phosphate ester type dispersant) manufactured by Kusumoto Chemicals, Ltd.; "RS-410", "RS-610", and "RS-710" (pH: 1.9) (phosphate ester type dispersant) of the "Phosphanol" series, manufactured by TOHO Chemical Industry Co., Ltd.; and "AKM-0531", "AFB-1521", "SC-0505K", and "SC-0708A" of the "Marialim" series manufactured by NOF Corp.

The basic dispersant usually contains a basic functional group such as a primary, a secondary, or a tertiary amino group; an ammonium group; an imino group; and a nitrogen-containing heterocyclic group such as pyridine, pyrimidine, pyrazine, imidazole, or triazole. The basic functional group may be neutralized by an acid such as an organic acid or an inorganic acid. Preferable examples of the basic dispersant may include a basic polymer dispersant containing a polymer chain such as a polyester chain. Preferable examples of the basic dispersant may include "PB-881" (polyamine type dispersant containing a polyester chain) manufactured by Ajinomoto Fine-Techno Co., Inc.

(E) The dispersant may be used singly or as a combination of two or more of them.

The amount (% by mass) of (E) the dispersant included in the resin composition may be 0% by mass, or more than 0% by mass, and is preferably 0.01% by mass or more, more preferably 0.1% by mass or more, especially preferably 0.2% by mass or more, preferably 5% by mass or less, more preferably 3% by mass or less, and especially preferably 2% by mass or less, relative to 100% by mass of the nonvolatile components in the resin composition. When the amount of (E) the dispersant is within the range described above, the relative magnetic permeability and the magnetic loss of the cured product of the resin composition can be effectively improved.

The amount (% by mass) of (E) the dispersant included in the resin composition may be 0% by mass, or more than 0% by mass, and is preferably 0.1% by mass or more, more preferably 1% by mass or more, especially preferably 2% by mass or more, preferably 30% by mass or less, more preferably 25% by mass or less, and especially preferably 20% by mass or less, relative to 100% by mass of the resin components in the resin composition. When the amount of (E) the dispersant is within the range described above, the relative magnetic permeability and the magnetic loss of the cured product of the resin composition can be effectively improved.

### <(F) Curing Accelerator>

The resin composition according to one embodiment of the present invention may further include (F) a curing accelerator as the optional component in combination with the (A) to (E) components described above. (F) The curing accelerator as the (F) component does not include those that fall under the components (A) to (E) described above. (F) The curing accelerator functions as a catalyst for the reaction of (B) the thermosetting resin so that curing of the resin composition can be accelerated.

Illustrative examples of (F) the curing accelerator may include a phosphorous type curing accelerator, an imidazole type curing accelerator, an amine type curing accelerator, a guanidine type curing accelerator, a metal type curing accelerator, and a urea type curing accelerator. (F) The curing accelerator may be used singly or in a combination of two or more of them. Among them, as for (F) the curing accelerator, a phosphorus type curing accelerator and an imidazole type curing accelerator are preferable, and a phosphorus type curing accelerator is more preferable.

Illustrative examples of the phosphorus type curing accelerator may include a phosphonium salt and a phosphine. Illustrative examples of the phosphonium salt may include: aliphatic phosphonium salts such as tetrabutylphosphonium bromide, tetrabutylphosphonium chloride, tetrabutylphosphonium acetate, tetrabutylphosphonium decanoate, tetrabutylphosphonium laurate, n-butylphosphonium tetraphenylborate, bis(tetrabutylphosphonium) pyromellitate, tetrabutylphosphonium hydrogenhexahydrophthalate, tetrabutylphosphonium 2,6-bis[(2-hydroxy-5-methylphenyl)methyl]-4-methylphenolate, and di-tert-butylmethylphosphonium tetraphenylborate; and aromatic phosphonium salts such as methyltriphenylphosphonium bromide, ethyltriphenylphosphonium bromide, propyltriphenylphosphonium bromide, butyltriphenylphosphonium bromide, benzyltriphenylphosphonium chloride, tetraphenylphosphonium bromide, p-tolyltriphenylphosphonium tetra-p-tolylborate, tetraphenylphosphonium tetraphenylborate, tetraphenylphosphonium tetra-p-tolylborate, triphenylethylphosphonium tetraphenylborate, tris(3-methylphenyl)ethylphosphonium tetraphenylborate, tris(2-methoxyphenyl)ethylphosphonium tetraphenylborate, (4-methylphenyl)triphenylphosphonium thiocyanate, tetraphenylphosphonium thiocyanate, and butyltriphenylphosphonium thiocyanate.

Illustrative examples of the phosphine may include: aliphatic phosphines such as tributylphosphine, tri-tert-butylphosphine, tri-octylphosphine, di-tert-butyl(2-butenyl)phosphine, di-tert-butyl(3-methyl-2-butenyl)phosphine, and tricyclohexylphosphine; aromatic phosphines such as dibutylphenylphosphine, di-tert-butylphenylphosphine, methyldiphenylphosphine, ethyldiphenylphosphine, butyldiphenylphosphine, diphenylcyclohexylphosphine, triphenylphosphine, tri-o-tolylphosphine, tri-m-tolylphosphine, tri-p-tolylphosphine, tris(4-ethylphenyl)phosphine, tris(4-propylphenyl)phosphine, tris(4-isopropylphenyl)phosphine, tris(4-butylphenyl)phosphine, tris(4-tert-butylphenyl)phosphine, tris(2,4-dimethylphenyl)phosphine, tris(2,5-dimethylphenyl)phosphine, tris(2,6-dimethylphenyl)phosphine, tris(3,5-dimethylphenyl)phosphine, tris(2,4,6-trimethylphenyl)phosphine, tris(2,6-dimethyl-4-ethoxyphenyl)phosphine, tris(2-methoxyphenyl)phosphine, tris(4-methoxyphenyl)phosphine, tris(4-ethoxyphenyl)phosphine, tris(4-tert-butoxyphenyl)phosphine, diphenyl-2-pyridylphosphine, 1,2-bis(diphenylphosphino)ethane, 1,3-bis(diphenylphosphino)propane, 1,4-bis(diphenylphosphino)butane, 1,2-bis(diphenylphosphino)acetylene, and 2,2'-bis(diphenylphosphino)diphenyl ether; aromatic phosphineborane complexes such as triphenylphosphinetriphenylborane; and aromatic phosphine-quinone addition products such as a triphenylphosphine/p-benzoquinone addition product.

As for the phosphorous type curing accelerator, a commercially available product may be used. Illustrative examples thereof may include "TBP-DA" manufactured by Hokko Chemical Industry Co., Ltd.

Illustrative examples of the imidazole type curing accelerator may include imidazole compounds such as 2-methylimidazole, 2-undecylimidazole, 2-heptadecylimidazole, 1,2-dimethylimidazole, 2-ethyl-4-methylimidazole, 1,2-dimethylimidazole, 2-ethyl-4-methylimidazole, 2-phenylimidazole, 2-phenyl-4-methylimidazole, 1-bezyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-metylimidazolyl-(1')]-ethyl-s-triazine, a 2,4-diamino-6-[2'-methylimidazolyl-(1')]-ethyl-s-triazine isocyanuric acid adduct, a 2-phenylimidazole isocyanuric acid adduct, 2-phenyl-4,5-dihydroxymethylimidazole, 2-phenyl-4-methyl-5-hydroxymethylimidazole, 2,3-dihydro-1H-pyrro[1,2-a]benzimidazole, 1-dodecyl-2-methyl-3-benzylimidazolium chloride, 2-methylimidazoline, and 2-phenylimidazoline; and adducts of these imidazole compounds with an epoxy resin. Among these, 2-ethyl-4-methylimidazole and 1-benzyl-2-phenylimidazole are preferable. As for the imidazole type curing accelerator, a commercially available product may be used. Illustrative examples thereof may include "P200-H50" manufactured by Mitsubishi Chemical Corp.; and "Curezol 2MZ", "2E4MZ", "Cl1Z", "Cl1Z-CN", "Cl1Z-CNS", "Cl1Z-A", "2MZ-OK", "2MA-OK", "2MA-OK-PW, "2MZA-PW", "2PHZ", "2PHZ-PW", "1B2PZ", and "1B2PZ-10M", all these being manufactured by Shikoku Chemicals Corp.

Illustrative examples of the amine type curing accelerator may include: trialkylamines such as triethylamine and tributylamine; and 4-dimethylaminopyridine, benzyl dimethyl amine, 2,4,6-tris(dimethylaminomethyl)phenol, 1,8-diazabicyclo(5,4,0)-undecene, 1,8-diazabicyclo[5,4,0]undecene-7,4-dimethylaminopyridine, and 2,4,6-tris(dimethylaminomethyl)phenol. Among these, 4-dimethylaminopyridine is preferable. As for the amine type curing accelerator, a commercially available product may be used. Illustrative examples thereof may include "PN-50", "PN-23", and "MY-25", manufactured by Ajinomoto Fine Techno Co., Ltd.

Illustrative examples of the guanidine type curing accelerator may include dicyandiamide, 1-methyl guanidine, 1-ethyl guanidine, 1-cyclohexyl guanidine, 1-phenyl guanidine, 1-(o-tolyl) guanidine, dimethyl guanidine, diphenyl guanidine, trimethyl guanidine, tetramethyl guanidine, pentamethyl guanidine, 1,5,7-triazabicyclo[4.4.0]deca-5-ene, 7-methyl-1,5,7-triazabicyclo[4.4.0]deca-5-ene, 1-methyl biguanide, 1-ethyl biguanide, 1-n-butyl biguanide, 1-n-octadecyl biguanide, 1,1-dimethyl biguanide, 1,1-diethyl biguanide, 1-cyclohexyl biguanide, 1-allyl biguanide, 1-phenyl biguanide, and 1-(o-tolyl) biguanide. Among these, dicyandiamide and 1,5,7-triazabicyclo[4.4.0]deca-5-ene are preferable.

Illustrative examples of the metal type curing accelerator may include organometallic complexes or organometallic salts of metals such as cobalt, copper, zinc, iron, nickel, manganese, and tin. Specific examples of the organometallic complex may include organic cobalt complexes such as cobalt (II) acetylacetonate and cobalt (III) acetylacetonate; organic copper complexes such as copper (II) acetylacetonate; organic zinc complexes such as zinc (II) acetylacetonate; organic iron complexes such as iron (III) acetylacetonate; organic nickel complexes such as nickel (II) acetylacetonate; and organic manganese complexes such as manganese (II) acetylacetonate. Illustrative examples of the organic metal salt may include zinc octylate, tin octylate, zinc naphthenate, cobalt naphthenate, tin stearate, and zinc stearate.

Illustrative examples of the urea type curing accelerator may include: 1,1-dimethylurea; aliphatic dimethylureas such as 1,1,3-trimethylurea, 3-ethyl-1,1-dimethylurea, 3-cyclohexyl-1,1-dimethylurea, and 3-cyclooctyl-1,1-dimethylurea; and aromatic dimethylureas such as 3-phenyl-1,1-dimethylurea, 3-(4-chlorophenyl)-1,1-dimethylurea, 3-(3,4-dichlorophenyl)-1,1-dimethylurea, 3-(3-chloro-4-methylphenyl)-1,1-dimethylurea, 3-(2-methylphenyl)-1,1-dimethylurea, 3-(4-methylphenyl)-1,1-dimethylurea, 3-(3,4-dimethylphenyl)-1,1-dimethylurea, 3-(4-isopropylphenyl)-1,1-dimethylurea, 3-(4-methoxyphenyl)-1,1-dimethylurea, 3-(4-nitrophenyl)-1,1-dimethylurea, 3-[4-(4-methoxyphenoxy)phenyl]-1,1-dimethylurea, 3-[4-(4-chlorophenoxy)phenyl]-1,1-dimethylurea, 3-[3-(trifluoromethyl)phenyl]-1,1-dimethylurea, N,N-(1,4-phenylene)bis(N',N'-dimethylurea), and N,N-(4-methyl-1,3-phenylene)bis(N',N'-dimethylurea) [toluenebisdimethylurea].

The amount (% by mass) of (F) the curing accelerator included in the resin composition may be 0% by mass, or more than 0% by mass, and is preferably 0.001% by mass or more, more preferably 0.005% by mass or more, especially preferably 0.01% by mass or more, preferably 3% by mass or less, more preferably 2% by mass or less, and especially preferably 1% by mass or less, relative to 100% by mass of the nonvolatile components in the resin composition.

The amount (% by mass) of (F) the curing accelerator included in the resin composition may be 0% by mass, or more than 0% by mass, and is preferably 0.01% by mass or more, more preferably 0.05% by mass or more, especially preferably 0.1% by mass or more, preferably 5% by mass or less, more preferably 2% by mass or less, and especially preferably 1% by mass or less, relative to 100% by mass of the resin components in the resin composition.

### <(G) Optional Additive>

The resin composition according to one embodiment of the present invention may further include (G) an optional additive as the optional component in combination with the (A) to (F) components described above. (G) The optional additive as the (G) component does not include those that fall under the (A) to (F) components described above.

Illustrative examples of (G) the optional component may include: radical-polymerizable compounds such as a maleimide type radical-polymerizable compound, a vinylphenyl type radical-polymerizable compound, a (meth)acrylic type radical-polymerizable compound, an allyl type radical-polymerizable compound, and a polybutadiene type radical-polymerizable compound; radical polymerization initiators such as a peroxide type radical polymerization initiator and an azo type radical polymerization initiator; inorganic particles (inorganic fillers) such as a silica particle; organic fillers such as a rubber particle; organic metal compounds such as an organic copper compound and an organic zinc compound; polymerization inhibitors such as hydroquinone, catechol, pyrogallol, and phenothiazine; leveling agents such as a silicone type leveling agent and an acrylic polymer type leveling agent; thickeners such as bentone and montmorillonite; antifoaming agents such as a silicone type antifoaming agent, an acrylic type antifoaming agent, a fluorine type antifoaming agent, and a vinyl resin type antifoaming agent; ultraviolet absorbers such as a benzotriazole type ultraviolet absorber; adhesion enhancers such as a urea silane; adhesion assisting agents such as a triazole type adhesion assisting agent, a tetrazole type adhesion assisting agent, and a triazine type adhesion assisting agent; antioxidants such as a hindered phenol type antioxidant; flame retardants such as phosphorous type flame retardants (for example, a phosphate ester compound, a phosphazene compound, a phosphinate compound, and red phosphorus), nitrogen type flame retardants (for example, melamine sulfate), halogen type flame retardants, and inorganic type flame retardants (for example, antimony trioxide); and stabilizers such as a borate type stabilizer, a titanate type stabilizer, an aluminate type stabilizer, a zirconate type stabilizer, an isocyanate type stabilizer, a carboxylate type stabilizer, and a carboxylic anhydride type stabilizer. (G) The optional additive may be used singly or in a combination of two or more of them.

### <(H) Solvent>

The resin composition according to one embodiment of the present invention may further include (H) a solvent as a volatile component in combination with the nonvolatile components such as the (A) to (G) components described above.

As for (H) the solvent, an organic solvent is usually used. Illustrative examples of (H) the solvent may include: ketone type solvents such as acetone, methyl ethyl ketone, methyl isobutyl ketone, and cyclohexanone; ester type solvents such as methyl acetate, ethyl acetate, butyl acetate, isobutyl acetate, isoamyl acetate, methyl propionate, ethyl propionate, and γ-butyrolactone; ether type solvents such as tetrahydropyran, tetrahydrofuran, 1,4-dioxane, diethyl ether, diisopropyl ether, dibutyl ether, and diphenyl ether; alcohol type solvents such as methanol, ethanol, propanol, butanol, and ethyleneglycol; ether ester type solvents such as 2-ethoxyethyl acetate, propyleneglycol monomethyl ether acetate, diethyleneglycol monoethyl ether acetate, ethyldiglycol acetate, γ-butyrolactone, and methyl methoxypropionate; ester alcohol type solvents such as methyl lactate, ethyl lactate, and methyl 2-hydroxyisobutyrate; ether alcohol type solvents such as 2-methoxypropanol, 2-methoxyethanol, 2-ethoxyethanol, propyleneglycol monomethyl ether, and diethyleneglycol monobutyl ether (butyl carbitol); amide type solvents such as N,N-dimethylformamide, N,N-dimethylacetamide, and N-methyl-2-pyrrolidone; sulfoxide type solvents such as dimethyl sulfoxide; nitrile type solvents such as acetonitrile and propionitrile; aliphatic hydrocarbon type solvents such as hexane, cyclopentane, cyclohexane, and methylcyclohexane; and aromatic hydrocarbon type solvents such as benzene, toluene, xylene, ethylbenzene, and trimethylbenzene. (H) The solvent may be used singly or as a combination of two or more of them.

The amount of (H) the solvent is set preferably such that the melt viscosity of the resin composition can be adjusted to an appropriate range. The amount of (H) the solvent may be, for example, 3% by mass or less, 1% by mass or less, 0.5% by mass or less, 0.1% by mass or less, or 0.01% by mass or less, relative to 100% by mass of the nonvolatile components in the resin composition. In particular, it is especially preferable that the resin composition does not contain (H) the solvent. When the amount of (H) the solvent is small, generation of a void due to volatilization of (H) the solvent can be suppressed. In addition, the handling property and workability of the resin composition can be improved.

### <Properties of Resin Composition>

The resin composition described above can be cured thermally. Therefore, the cured product of the resin composition can be obtained by thermally curing the resin composition. Normally, among the components included in the resin composition, volatile components such as (H) the solvent may be volatilized by heat during thermal curing, while nonvolatile components such as the (A) to (G) components are not volatilized by heat during thermal curing. Thus, the cured product of the resin composition may contain nonvolatile components of the resin composition or reaction products thereof.

According to the resin composition of the present embodiment, the cured product having improved relative magnetic permeability and magnetic loss can be obtained. Usually, the cured product of the resin composition according to the present embodiment has a higher magnetic permeability and a lower magnetic loss than a cured product of a conventional resin composition containing a Fe-Ni type alloy magnetic powder not containing Si, a cured product of a conventional resin composition containing a Ni type alloy magnetic powder, and a cured product of a conventional resin composition containing a Fe-Si-Cr type alloy magnetic powder.

Therefore, by using the resin composition described above, the cured product having a high relative magnetic permeability can be obtained. When the relative magnetic permeability of the cured product of the resin composition is measured, for example, at a measurement frequency of 20 MHz and a room temperature of 23°C, the relative magnetic permeability is preferably 14.8 or more, more preferably 15.0 or more, and especially preferably 15.1 or more. There is no particular restriction in the upper limit of the relative magnetic permeability; thus, the upper limit may be, for example, 35.0 or less, 30.0 or less, 25.0 or less, or 23.0 or less. The relative magnetic permeability of the cured product can be measured by the method described in Examples, using the cured product obtained by curing the resin composition under the conditions of, for example, 190°C for 90 minutes.

By using the resin composition described above, the cured product having a low magnetic loss can be obtained. The magnetic loss can be expressed by the magnetic loss tangent tanδ. Usually, the smaller the magnetic loss tangent tanδ is, the smaller the magnetic loss is. When the magnetic loss tangent tanδ of the cured product of the resin composition is measured, for example, at a measurement frequency of 20 MHz and a room temperature of 23°C, the magnetic loss tangent tanδ is preferably 0.020 or less, more preferably 0.017 or less, and especially preferably 0.015 or less. The magnetic loss tangent tanδ of the cured product can be measured by the method described in Examples, using the cured product obtained by curing the resin composition under the condition of, for example, 190°C for 90 minutes.

Although crystalline alloy powders such as an alloy powder containing Fe and Ni can generally have a high relative magnetic permeability, these tend to have a large magnetic loss. Therefore, in prior technique, it has been difficult to obtain the cured product having a high relative magnetic permeability and a low magnetic loss. In view of these circumstances in the prior technique, the above-mentioned advantageous effects of the resin composition, the effects that enable to improve both the relative magnetic permeability and the magnetic loss, are industrially beneficial.

There is no particular restriction in the form of the resin composition. Thus, the resin composition may be in a solid form or in a pasty form having flowability. For example, the resin composition may be made to a pasty resin composition using a solvent or a pasty resin composition not containing a solvent by using a liquid thermosetting resin such as a liquid epoxy resin. When the amount of the solvent in the resin composition is small, or when no solvent is contained therein, not only generation of a void due to solvent volatilization can be suppressed, but also handling properties and workability of the resin composition can be improved.

Taking advantage of these excellent properties, the resin composition may be preferably used as the resin composition for production of an inductor. For example, it is preferable to use the resin composition described above as the hole-filling resin composition to fill a hole in the substrate of a circuit board. It is also preferable that the resin composition described above is used, for example, to form a cured product layer on a circuit board. In order to facilitate the application to these uses, the resin composition may be used in a pasty form or in a form of a resin sheet containing a layer of the resin composition.

### <Production Method of Resin Composition>

The resin composition according to one embodiment of the present invention can be produced, for example, by mixing the above-mentioned components. The above-mentioned components may be mixed in part or in whole at the same time or in sequence. During the course of mixing these components, the temperature may be set as appropriate; therefore, temporarily or throughout the entire process, heating and/or cooling may be carried out. In addition, in the course of mixing of these components, stirring or shaking may be carried out. In addition, defoaming may be carried out under a low-pressure condition, such as under a vacuum condition.

### <Magnetic Paste>

The magnetic paste according to one embodiment of the present invention includes the above-mentioned resin composition. The magnetic paste is usually a flowable paste containing the resin composition, and thus this may be preferably used for filling a hole by a printing method. The magnetic paste may contain only the resin composition described above, or may contain any optional component in combination with the resin composition. Preferably, the pasty resin composition as it is may be used as the magnetic paste.

It is preferable that the magnetic paste is in the pasty form at 23°C. The viscosity of the magnetic paste at 23°C is preferably 20 Pa·s or more, more preferably 25 Pa·s or more, still more preferably 30 Pa·s or more, and especially preferably 50 Pa·s or more, and is preferably 200 Pa·s or less, more preferably 180 Pa·s or less, and still more preferably 160 Pa·s or less. The viscosity can be measured, for example, using an E-type viscometer ("RE-80U" manufactured by Toki Sangyo Co., Ltd., 3° x R9.7 rotor) with a sample volume of 0.22 ml and a rotation number of 5 rpm.

### <Resin Sheet>

The resin sheet according to one embodiment of the present invention includes a support and a resin composition layer formed on the support. The resin composition layer includes the resin composition described above, and includes preferably only the resin composition.

From the viewpoint of thinning, the thickness of the resin composition layer is preferably 250 µm or less, and more preferably 200 µm or less. The lower limit of the thickness of the resin composition layer may be, for example, 5 µm or more, or 10 µm or more.

Illustrative examples of the support may include a film of a plastic material, metal foil, and a releasing paper; a film formed of a plastic material and metal foil are preferable.

When the film of a plastic material is used as the support, illustrative examples of the plastic material may include: polyesters such as polyethylene terephthalate (hereinafter, this may be simply referred to as "PET") and polyethylene naphthalate (hereinafter, this may be simply referred to as "PEN"); polycarbonate (hereinafter, this may be simply referred to as "PC"); acrylic polymers such as polymethyl methacrylate ("PMMA"); a cyclic polyolefin; triacetyl cellulose ("TAC"); polyether sulfide ("PES"); polyether ketone; and polyimide. Among these, polyethylene terephthalate and polyethylene naphthalate are preferable; an inexpensive polyethylene terephthalate is especially preferable.

In the case that metal foil is used as the support, illustrative examples of the metal foil may include copper foil and aluminum foil; copper foil is preferable. As for the copper foil, the foil formed of a copper single metal or an alloy of copper with other metal (for example, tin, chromium, silver, magnesium, nickel, zirconium, silicon, and titanium) may be used.

The support may have been subjected to a treatment such as a mat treatment or a corona treatment on the surface to be bonded with the resin composition layer.

As for the support, a releasing layer-attached support having a releasing layer on the surface to be bonded with the resin composition layer may be used. The releasing agent that is used in the releasing layer of the releasing layer-attached support may be one or more releasing agents selected from the group consisting of, for example, an alkyd type releasing agent, a polyolefin type releasing agent, a urethane type releasing agent, and a silicone type releasing agent. As for the releasing layer-attached support, a commercially available product thereof may be used. Illustrative examples thereof may include PET films having a releasing layer mainly composed of a silicone type releasing agent or an alkyd resin type releasing agent, such as "PET501010", "SK-1", "AL-5", and "AL-7", all being manufactured by Lintech Corp.; "Lumirror T60" manufactured by Toray Industries, Inc.; "PUREX" manufactured by Teijin Limited; and "UNIPEEL" manufactured by Unitika, Ltd.

There is no particular restriction in the thickness of the support; but the range of 5 µm to 75 µm is preferable, and the range of 10 µm to 60 µm is more preferable. When the release layer-attached support is used, it is preferable that the thickness of the entire release layer-attached support is within the range described above.

In the resin sheet, a protective film that is conformed to the support may be formed on the surface of the resin composition layer not in contact with the support (namely, on the surface opposite to the support). There is no particular restriction in the thickness of the protective film; the thickness is, for example, 1 µm to 40 um. When the protective film is formed, the surface of the resin composition layer can be prevented from attachment of dirt and from formation of a scar.

The resin sheet can be produced, for example, by applying the resin composition onto the support by using a die coater or the like to form the resin composition layer. If necessary, the organic solvent may be mixed with the resin composition before applying onto the support. When the organic solvent is used, drying may be carried out after application, if necessary.

Drying may be carried out, for example, by a method such as heating or blowing a hot air. There is no particular restriction in the drying condition; the drying may be carried out in such a way as to bring the content of the solvent in the resin composition layer preferably to 10% by mass or less, and more preferably to 5% by mass or less. The resin composition layer can be formed by drying the resin composition in the temperature range of 50°C to 150°C and the time range of 3 minutes to 10 minutes, although these conditions vary depending on the components included in the resin composition.

The resin sheet can be rolled up so as to be stored. When the resin sheet includes the protective film, usually the resin sheet can be used by removing the protective film.

### <Circuit Board and Production Method Thereof>

The circuit board includes the cured product of the resin composition described above. There is no restriction in the specific structure of the circuit board so far as the cured product of the resin composition is included therein. The circuit board according to a first example includes a substrate having a hole and a cured product of the resin composition that is filled in the hole. The circuit board according to a second example has a cured product layer that contains the cured product of the resin composition. Hereinafter, the production methods of the circuit boards according to the first example and the second example will be described. However, the circuit boards and the production methods thereof are not limited to the first example and the second example to be described below.

### <Circuit Board According to the First Example>

The circuit board according to the first example includes a substrate formed with a hole and a cured product of the resin composition filled in the hole. This circuit board can be produced, for example, by a production method that includes:
(1) a step of filling a hole in the substrate with the resin composition, and
(2) a step of thermally curing the resin composition to obtain the cured product. The production method of the circuit board according to the first example may further include
(3) a step of polishing a surface of the cured product or of the resin composition,
(4) a step of conducting a roughening treatment to the cured product, and
(5) a step of forming a conductor layer on the cured product. Usually, the steps (1) through (5) may be carried out sequentially in the order of the step (1), the step (2), the step (3), the step (4), and the step (5). The step (2) may be carried out after the step (3). In the production method of the circuit board according to the first example, it is preferable to form the cured product by using the resin composition in the form of a paste. In the explanation below, the example will be described in which a substrate formed with a through hole as the hole that goes through the substrate in the thickness direction is used.

### <Step (1)>

The step (1) usually includes a step of preparing a substrate formed with a through hole. The substrate may be prepared by purchasing from the market. Alternatively, the substrate may be prepared by producing it using a suitable material. Hereinafter, the production method of the substrate according to one example will be described.

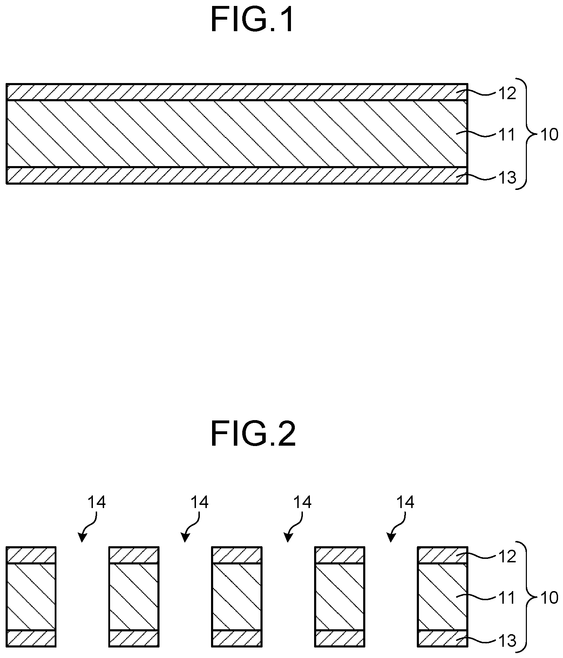

FIG. 1 is a schematic cross sectional view illustrating a core substrate 10 that is prepared in the production method of the circuit board according to the first example of one embodiment of the present invention. The step of preparing the substrate may include a step of preparing the core substrate 10, as illustrated in FIG. 1. The core substrate 10 usually includes a supporting substrate 11. Illustrative examples of the supporting substrate 11 may include insulating substrates such as a glass epoxy substrate, a metal substrate, a polyester substrate, a polyimide substrate, a BT resin substrate, and a thermosetting type polyphenylene ether substrate. On the supporting substrate 11, a metal layer may be formed. The metal layer may be formed on one surface of the supporting substrate 11, or on both surfaces of the substrate. Here, the example is illustrated in which a metal layer 12 and a metal layer 13 are formed on both the surfaces of the supporting substrate 11. The metal layers 12 and 13 each may be, for example, a layer formed of a metal such as copper. The metal layers 12 and 13 may be, for example, copper foil such as carrier-attached copper foil, or a metal layer formed of a material of the conductor layer to be described later.

FIG. 2 is a schematic cross sectional view illustrating the core substrate 10 formed with a through hole 14 in the production method of the circuit board according to the first example of one embodiment of the present invention. The step of preparing the substrate may include a step of forming the through hole 14 in the core substrate 10, as an example illustrated in FIG. 2. The through hole 14 can be formed, for example, by drilling, laser irradiation, or plasma irradiation. Usually, the through hole 14 can be formed by forming a penetrating hole that goes through the core substrate 10. In a specific example, formation of the through hole 14 can be performed by using a drilling machine that is commercially available. Illustrative examples of the commercially available drilling machine may include "ND-1S211" manufactured by Hitachi Via Mechanics, Ltd.

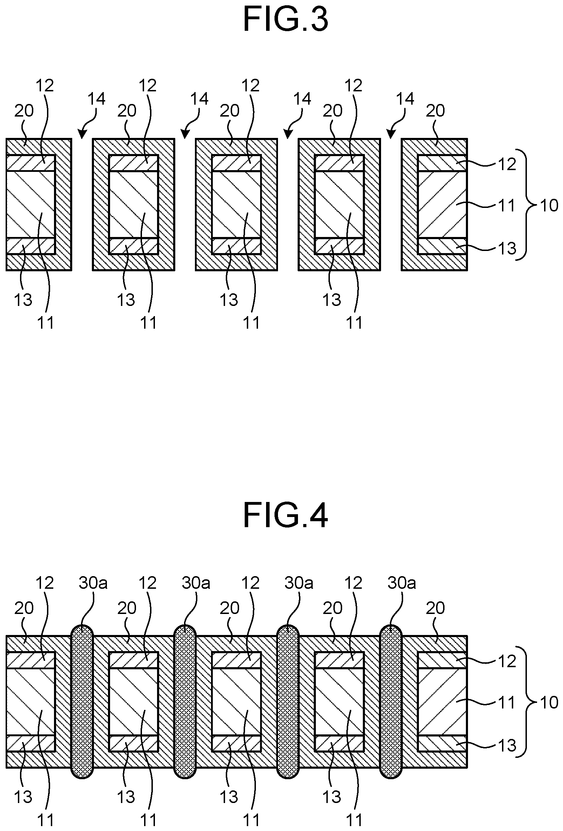

FIG. 3 is a schematic cross sectional view illustrating the core substrate 10 formed with a plated layer 20 in the through hole 14 in the production method of the circuit board according to the first example of one embodiment of the present invention. The step of preparing the substrate may include, after the core substrate 10 is subjected to the roughening treatment as needed, a step of forming the plated layer 20 as illustrated in FIG. 3. The roughening treatment may be performed with any of a dry roughening treatment and a wet roughening treatment. Illustrative examples of the dry roughening treatment may include a plasma treatment. Illustrative examples of the wet roughening treatment may include a method in which a swelling treatment by a swelling liquid, a roughening treatment by an oxidant, and a neutralizing treatment by a neutralizing solution are performed in this order. The plated layer 20 may be formed by a plating method. The procedure to form the plated layer 20 by the plating method may be the same as the procedure in formation of the conductor layer at the step (5) to be described later. Here, the explanation will be made as to the example in which the plated layer 20 is formed inside the through hole 14, on the surface of the metal layer 12, and on the surface of the metal layer 13.

FIG. 4 is a schematic cross sectional view illustrating the state of filling the through hole of the core substrate 10 with a resin composition 30a in the production method of the circuit board according to the first example of one embodiment of the present invention. The step (1) includes, after the core substrate 10 formed with the through hole 14 is prepared, filling the through hole 14 in the core substrate 10 with the resin composition 30a, as illustrated in FIG. 4. The filling may be performed, for example, by a printing method. Illustrative examples of the printing method may include a method in which the resin composition 30a is printed to the through hole 14 via a squeegee, a method in which the resin composition 30a is printed via a cartridge, a method in which the resin composition 30a is printed by a mask printing, a roll coating method, and an inkjet method.

### <Step (2)>

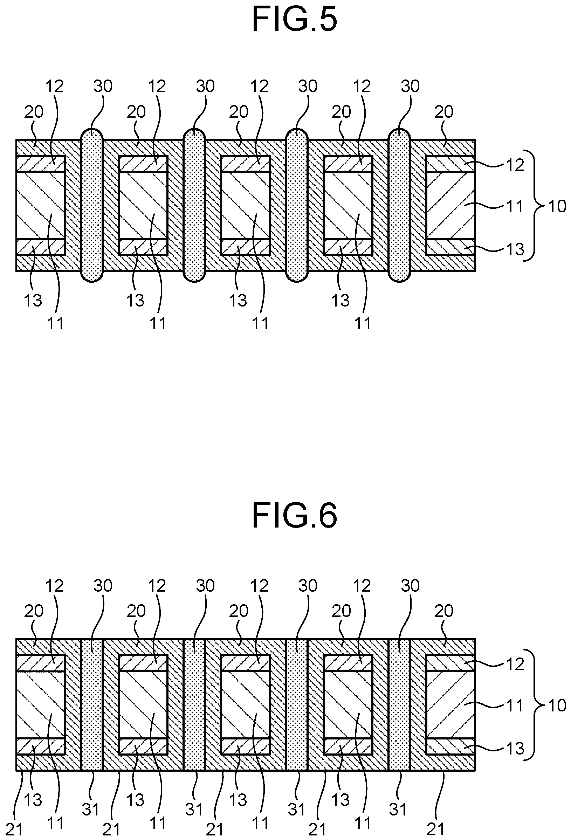

FIG. 5 is a schematic cross sectional view to explain the step (2) in the production method of the circuit board according to the first example of one embodiment of the present invention. The step (2) includes, after filling the through hole 14 with the resin composition 30a, curing the resin composition 30a to form a cured product 30, as illustrated in FIG. 5.

Curing of the resin composition 30a is usually performed by a thermal curing. The condition of the thermal curing of the resin composition 30a may be set as appropriate so far as curing of the resin composition 30a is proceeded. The curing temperature is preferably 120°C or higher, more preferably 130°C or higher, and still more preferably 150°C or higher, and is preferably 245°C or lower, more preferably 220°C or lower, and still more preferably 200°C or lower. The curing time is preferably 5 minutes or longer, more preferably 10 minutes or longer, and still more preferably 15 minutes or longer, and is preferably 120 minutes or shorter, more preferably 110 minutes or shorter, and still more preferably 100 minutes or shorter.

The curing degree of the cured product 30 that is obtained at the step (2) is preferably 800 or more, more preferably 85% or more, and still more preferably 90% or more. The curing degree can be measured by using, for example, a differential scanning calorimeter.

The production method of the circuit board according to the first example may include, after filling the through hole 14 with the resin composition 30a and before curing the resin composition 30a, a step of heating the resin composition 30a at a temperature lower than the curing temperature (preliminary heating step). For example, prior to curing the resin composition 30a, the resin composition 30a may be preliminarily heated at a temperature of usually 50°C or higher and lower than 120°C (preferably 60°C or higher and 110°C or lower, more preferably 70°C or higher and 100°C or lower), usually for 5 minutes or longer (preferably for 5 minutes to 150 minutes, more preferably for 15 minutes to 120 minutes).

### <Step (3)>

FIG. 6 is a schematic cross sectional view to explain the step (3) in the production method of the circuit board according to the first example of one embodiment of the present invention. When the through-hole 14 is filled with the resin composition 30a in the step (1), an excess of the resin composition 30a may protrude to or adhere with the outside the through-hole 14. Therefore, the resin composition 30a may be present not only inside the through hole 14 but also outside the through hole 14. The step (3) includes polishing the excess of the cured product 30 protruding from or adhering to the core substrate 10, as illustrated in FIG. 6. The excess of the cured product 30 is removed by polishing, so that the surface of the cured product 30 can be flattened. A surface (polished surface) 31 of the cured product 30 that had been flattened by polishing may usually form a plane that is flush with a surrounding surface 21 of the polished surface 31 (e.g., the surface of the core substrate 10 and the surface of the plated layer 20).

As for the polishing method of the cured product 30, the method with which the excess of the cured product 30 protruding from or adhering to the core substrate 10 can be removed may be used. Illustrative examples of the polishing method as described above may include a buff polishing method, a belt polishing method, and a ceramic polishing method. Illustrative examples of the buff polishing equipment that is commercially available may include "NT-700IM" manufactured by Ishiihyoki Co., Ltd.

From the viewpoint of enhancing the adhesion with the conductor layer, the arithmetic average roughness (Ra) of the polished surface (surface after curing) 31 of the cured product 30 is preferably 300 nm or more, more preferably 350 nm or more, and still more preferably 400 nm or more. The upper limit thereof is preferably 1000 nm or less, more preferably 900 nm or less, and still more preferably 800 nm or less. The surface roughness (Ra) can be measured, for example, by using a non-contact type surface roughness meter.

The production method of the circuit board according to the first example may include, after the step (3), a step of subjecting the cured product 30 to a heattreatment in order to further increase the curing degree of the cured product 30. As for the temperature at this heat treatment, the aforementioned curing temperature may be applied. Specifically, the heat treatment temperature is preferably 120°C or higher, more preferably 130°C or higher, and still more preferably 150°C or higher, and is preferably 245°C or lower, more preferably 220°C or lower, and still more preferably 200°C or lower. The heat treatment period is preferably 5 minutes or longer, more preferably 10 minutes or longer, and still more preferably 15 minutes or longer, and is preferably 90 minutes or shorter, more preferably 70 minutes or shorter, and still more preferably 60 minutes or shorter.

In the case where the step (3) is carried out before the step (2), a preliminary heating treatment may be carried out to heat the resin composition at a temperature lower than the curing temperature of the resin composition before the step (3). The temperature at the preliminary heating treatment is preferably 100°C or higher, more preferably 110°C or higher, and still more preferably 120°C or higher, and is preferably 245°C or lower, more preferably 220°C or lower, and still more preferably 200°C or lower. The heat treatment period is preferably 5 minutes or longer, more preferably 10 minutes or longer, and still more preferably 15 minutes or longer, and is preferably 90 minutes or shorter, more preferably 70 minutes or shorter, and still more preferably 60 minutes or shorter.

### <Step (4)>

The step (4) includes subjecting the cured product 30 to the roughening treatment (desmear treatment). With the roughening treatment, the surface of the cured product 30 is roughened. When the surface of the cured product 30 has been polished, this step usually includes subjecting the polished surface 31 to the roughening treatment (desmear treatment). There is no particular restriction in the procedure and condition of the roughening treatment; for example, the procedure and condition that are used in the production method of a multilayer printed wiring board may be used. In a specific example, the roughening treatment to the cured product 30 may be performed by conducting the method including a swelling treatment with a swelling liquid, a roughening treatment with an oxidant, and a neutralizing treatment with a neutralizing solution in this order.

Illustrative examples of the swelling liquid that may be used in the swelling treatment may include an alkaline solution and a surfactant solution; here, the alkaline solution is preferable. As for the alkaline solution as the swelling liquid, a sodium hydroxide solution and a potassium hydroxide solution are more preferable. Illustrative examples of the swelling liquid that is commercially available may include "Swelling Dip Securiganth P" and "Swelling Dip Securiganth SBU", which are both manufactured by Atotech Japan Co., Ltd.

The swelling treatment with the swelling liquid can be carried out, for example, by immersing the cured product 30 into the swelling liquid at the temperature of 30°C to 90°C for the period of 1 minute to 20 minutes. From the viewpoint of suppressing the swelling of the resin included in the cured product 30 to a suitable level, it is preferable that the cured product 30 is immersed into the swelling liquid at the temperature of 40°C to 80°C for the period of 5 minutes to 15 minutes.

Illustrative examples of the oxidant that may be used in the roughening treatment with the oxidant may include an alkaline permanganate solution having potassium permanganate or sodium permanganate dissolved into a sodium hydroxide aqueous solution. The roughening treatment using the oxidant such as the alkaline permanganate solution is preferably carried out by immersing the cured product 30 into the oxidant solution heated at 60°C to 80°C for the period of 10 minutes to 30 minutes. The concentration of the permanganate salt in the alkaline permanganate solution is preferably in the range of 5% by mass to 10% by mass. Illustrative examples of the oxidant that is commercially available may include alkaline permanganate solutions such as "Concentrate Compact P" and "Dosing Solution Securiganth P", both of which are manufactured by Atotech Japan, Co., Ltd.

The neutralizing solution that may be used in the neutralizing treatment is preferably an acidic aqueous solution. A commercially available neutralizing solution is, for example, "Reduction Solution Securigance P" manufactured by Atotech Japan Co., Ltd. The neutralizing treatment with the neutralizing solution can be carried out by immersing the treated surface, which has been subjected to the roughening treatment using the oxidant solution, into the neutralizing solution in the temperature range of 30°C to 80°C for the period of 5 minutes to 30 minutes. From the viewpoint of workability, it is preferable to immerse the cured product 30, which has been subjected to the roughening treatment using the oxidant solution, into the neutralizing solution in the temperature range of 40°C to 70°C for the period of 5 minutes to 20 minutes.

From a viewpoint of improving the adhesion with a conductor layer, the arithmetic average roughness (Ra) of the surface of the cured product 30 after the roughening treatment is preferably 300 nm or more, more preferably 350 nm or more, and still more preferably 400 nm or more. The upper limit thereof is preferably 1500 nm or less, more preferably 1200 nm or less, and still more preferably 1000 nm or less. The surface roughness (Ra) can be measured, for example, by using a non-contact type surface roughness meter.

### <Step (5)>

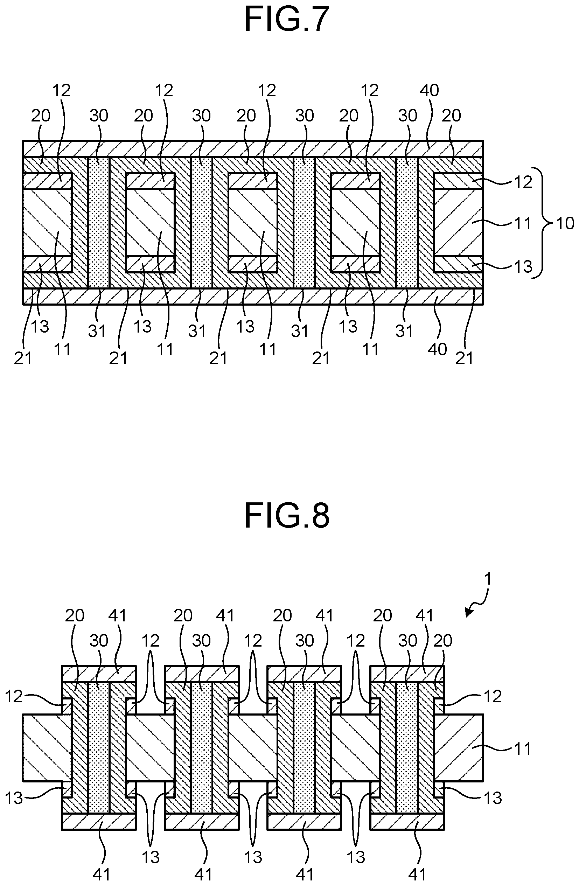

FIG. 7 is a schematic cross sectional view to explain the step (5) in the production method of the circuit board according to the first example of one embodiment of the present invention. The step (5) includes forming a conductor layer 40 on the polished surface 31 of the cured product 30, as illustrated in FIG. 7. Here, the example is illustrated in which the conductor layer 40 is formed not only on the polished surface 31 of the cured product 30 but also on the surrounding surface 21 (for example, the surface of the core substrate 10 and the surface of the plated layer 20). In FIG. 7, the example that the conductor layer 40 is formed on both sides of the core substrate 10 is illustrated; but the conductor layer 40 may be formed on only one side of the core substrate 10.

FIG. 8 is a schematic cross sectional view to explain the step (5) in the production method of the circuit board according to the first example of one embodiment of the present invention. As illustrated in FIG. 8, after the conductor layer 40 is formed, the step (5) may include removing a part of the conductor layer 40, the metal layer 12, the metal layer 13, and the plated layer 20 to form a patterned conductor layer 41 by a treatment such as etching.

Illustrative examples of the method for forming the conductor layer 40 may include a plating method, a sputtering method, and a vapor deposition method. Among these, a plating method is preferable. In a preferable embodiment, the surface of the cured product 30 (and the plated layer 20) is plated with a suitable method such as a semi-additive method or a full additive method, so that the patterned conductor layer 41 having an intended wiring pattern may be formed. Illustrative examples of the material of the conductor layer 40 may include: single metals such as gold, platinum, palladium, silver, copper, aluminum, cobalt, chromium, zinc, nickel, titanium, tungsten, iron, tin, and indium; and alloys of two or more metals selected from the group consisting of gold, platinum, palladium, silver, copper, aluminum, cobalt, chromium, zinc, nickel, titanium, tungsten, iron, tin, and indium. Among these, from the viewpoints of general applicability, cost, easiness in patterning, and the like, preferably usable are chromium, nickel, titanium, aluminum, zinc, gold, palladium, silver, and copper, as well as a nickel-chromium alloy, a copper-nickel alloy, and a coppertitanium alloy. More preferable are chromium, nickel, titanium, aluminum, zinc, gold, palladium, silver, and copper, as well as a nickel-chromium alloy. Copper is still more preferably used.

Here, the example of the method for forming the patterned conductor layer 41 on the polished surface 31 of the cured product 30 will be explained in detail. A plating seed layer is formed on the polished surface 31 of the cured product 30 by an electroless plating. Next, on the resulting plating seed layer, an electroplated layer is formed by an electroplating. Then, as needed, an unnecessary plating seed layer is removed by a treatment such as etching, so that the patterned conductor layer 41 having an intended wiring pattern can be formed. After the patterned conductor layer 41 is formed, in order to improve the adhesion strength of the patterned conductor layer 41, an annealing treatment may be performed as needed. The annealing treatment can be performed, for example, by heating in the temperature range of 150°C to 200°C for the period of 20 minutes to 90 minutes.

From the viewpoint of thinning, the thickness of the patterned conductor layer 41 is preferably 70 µm or less, more preferably 60 µm or less, still more preferably 50 µm or less, even still more preferably 40 µm or less, and especially preferably 30 µm or less, 20 µm or less, 15 µm or less, or 10 µm or less. The lower limit thereof is preferably 1 µm or more, more preferably 3 µm or more, and still more preferably 5 um or more.

By the method described above, a circuit board 1 including the cured product 30 of the resin composition 30a can be produced.

### <Circuit Board According to Second Example>

The circuit board according to a second example includes a cured product layer including the cured product of the resin composition. Preferably, the cured product layer includes only the cured product of the resin composition. It is preferable that the cured product layer is formed by using a resin sheet. This circuit board can be produced, for example, by a production method that includes:
(i) a step of forming a cured product layer on an inner layer substrate,
(ii) a step of forming a hole in the cured product layer,
(iii) a step of roughening a surface of the cured product layer, and
(iv) a step of forming a conductor layer on the surface of the cured product layer.

### <Step (i)>

The step (i) includes forming a cured product layer on the inner layer substrate. Preferably, the step (i) includes laminating the resin sheet onto the inner layer substrate in such a way that the resin composition layer is adhered with the inner layer substrate and forming the cured product layer. For example, the resin sheet is laminated to the inner layer substrate in such a way that the resin composition layer is adhered with the inner layer substrate, and then, the resin composition layer is thermally cured to form the cured product layer.

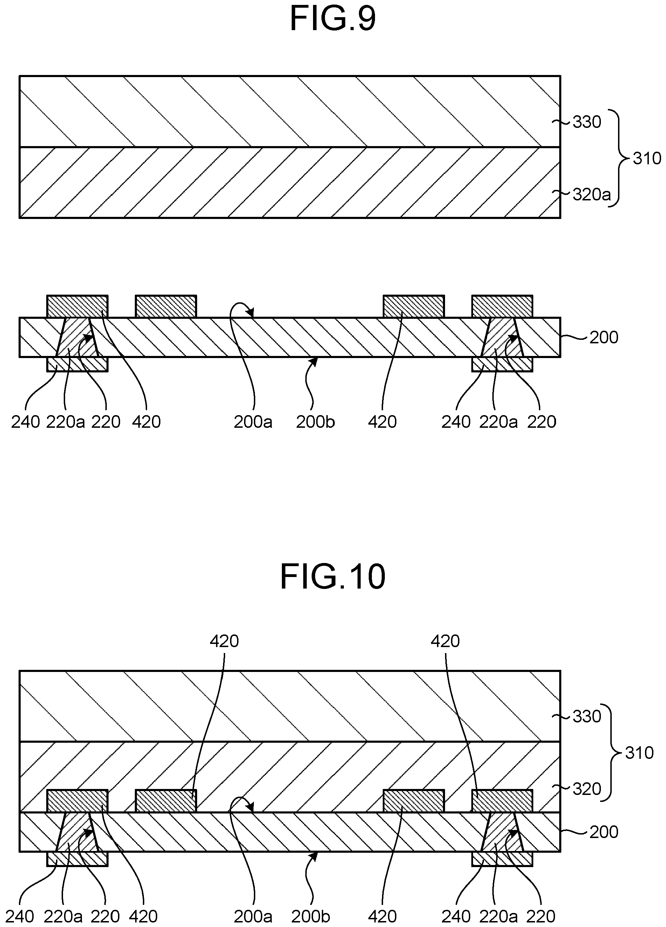

FIG. 9 is a schematic cross sectional view to explain the step (i) in the production method of the circuit board according to the second example of one embodiment of the present invention. As illustrated in FIG. 9, a resin sheet 310 including a support 330 and a resin composition layer 320a formed on the support 330 is prepared. Then, the resin sheet 310 and an inner layer substrate 200 are laminated such that the resin composition layer 320a is adhered with the inner layer substrate 200.

An insulating substrate may be used as the inner layer substrate 200. Illustrative examples of the inner layer substrate 200 may include insulating substrates such as a glass epoxy substrate, a metal substrate, a polyester substrate, a polyimide substrate, a BT resin substrate, and a thermosetting type polyphenylene ether substrate. The inner layer substrate 200 may be an inner layer circuit board having a wiring or the like incorporated in the thickness thereof.

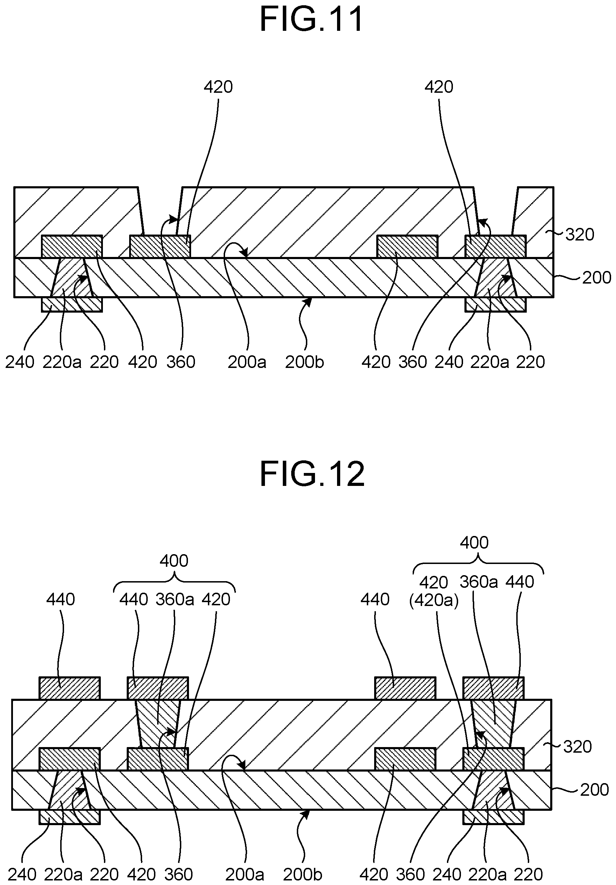

The inner layer substrate 200 illustrated in this example included a first conductor layer 420 formed on a first main surface 200a and an external terminal 240 formed on a second main surface 200b. The first conductor layer 420 may include a plurality of wires. Note that, in the example illustrated in FIG. 9, only the wiring that constitutes a coil-shaped conductive structural body 400 (see FIG. 12) of an inductor element is illustrated. The external terminal 240 may be a terminal for electrical connection to an external device or the like that is not illustrated in the drawing. The external terminal 240 can be configured as part of a conductor layer formed on the second main surface 200b.

The conductor material that can constitute the first conductor layer 420 and the external terminal 240 may be, for example, the same as the material of the conductor layer described in the first example.

The first conductor layer 420 and the external terminal 240 may have any of a monolayer structure and a multi-layer structure in which two or more layers formed of single-metal layers or alloy layers formed of different metals or alloys are laminated. The thicknesses of the first conductor layer 420 and of the external terminal 240 may be the same as that of a second conductor layer 440 to be described later.

The line (L)/space (S) ratio of the first conductor layer 420 and of the external terminal 240 is not particularly restricted. From the viewpoint of reducing a surface irregularity thereby obtaining the cured product layer having an excellent smoothness, the ratio is usually 900 µm/900 um or less, preferably 700 µm/700 µm or less, more preferably 500 µm/500 um or less, still more preferably 300 µm/300 um or less, and further still more preferably 200 µm/200 µm or less. There is no particular restriction in the lower limit of the line/space ratio; but from the viewpoint of enhancing an embedding property of the resin composition layer into the space, the lower limit is preferably 1 µm/1 µm or more.

The inner layer substrate 200 may have a plurality of through holes 220 that go through the inner layer substrate 200 from the first main surface 200a to the second main surface 200b. In the through hole 220, an inside-the-through-hole wiring 220a is formed. The inside-the-through-hole wiring 220a electrically connects the first conductor layer 420 with the external terminal 240.

Adhesion of the resin composition layer 320a with the inner layer substrate 200 can be performed, for example, by hot-pressing of the resin sheet 310 to the inner layer substrate 200 by pressing from the side of the support 330. Illustrative examples of the member (hereinafter, this member may be referred to as "hot-pressing member") used for the hot-pressing of the resin sheet 310 to the inner layer substrate 200 may include a heated metal plate (e.g., stainless steel (SUS) mirror plate) and a metal roll (SUS roll). Here, it is preferable that the hot-pressing member is not pressed in direct contact with the resin sheet 310 but is pressed via an sheet or the like formed of an elastic material such as a heat-resistant rubber in such a way that the resin sheet 310 can well follow the irregularity on the surface of the inner layer substrate 200.

The temperature at the time of the hot-pressing is preferably 80°C to 160°C, more preferably 90°C to 140°C, and still more preferably 100°C and 120°C. The pressure at the time of the hot-pressing is preferably 0.098 MPa to 1.77 MPa, and more preferably 0.29 MPa to 1.47 MPa. The period at the time of the hot-pressing is preferably 20 seconds to 400 seconds, and more preferably 30 seconds to 300 seconds. It is preferable that the adhesion of the resin sheet with the inner layer substrate is performed under the condition of a reduced pressure of 26.7 hPa or less.

Adhesion of the resin composition layer 320a of the resin sheet 310 with the inner layer substrate 200 can be performed by using a commercially available vacuum laminator. Illustrative examples of the commercially available vacuum laminator may include a vacuum pressing laminator manufactured by Meiki Co., Ltd. and a vacuum applicator manufactured by Nikko-Materials Co., Ltd.

After adhesion of the resin sheet 310 with the inner layer substrate 200, the resin sheet 310 thereby laminated may be subjected to, for example, a flattening treatment by pressing the hot-pressing member from the side of the support 330 under a normal pressure (under an atmospheric pressure). The pressing conditions in the flattening treatment may be the same as the hot-pressing conditions in the aforementioned lamination. The flattening treatment can be performed by a commercially available laminator. The lamination and the flattening treatments may be carried out continuously by using the commercially available vacuum laminator described before.

FIG. 10 is a schematic cross sectional view to explain the step (i) in the production method of the circuit board according to the second example of one embodiment of the present invention. After the resin sheet 310 is laminated onto the inner layer substrate 200, the resin composition layer 320a is cured to form the cured product layer. In this example, as illustrated in FIG. 10, the resin composition layer 320a that has been adhered with the inner layer substrate 200 is thermally cured to form a first cured product layer 320.

Conditions of the thermal curing of the resin composition layer 320a may be set as appropriate so far as curing of the resin composition can be proceeded. The curing temperature is preferably 120°C or higher, more preferably 130°C or higher, and still more preferably 150°C or higher, and is preferably 245°C or lower, more preferably 220°C or lower, and still more preferably 200°C or lower. The curing time is preferably 5 minutes or longer, more preferably 10 minutes or longer, and still more preferably 15 minutes or longer, and is preferably 120 minutes or shorter, more preferably 110 minutes or shorter, and still more preferably 100 minutes or shorter.

The support 330 may be removed between after the thermal curing at the step (i) and the step (ii), or it may be removed after the step (ii).

From the viewpoint of enhancing the adhesion with the plating, the arithmetic average roughness (Ra) of the cured product layer before the roughening treatment is preferably 300 nm or more, more preferably 350 nm or more, and still more preferably 400 nm or more. The upper limit thereof is preferably 1000 nm or less, more preferably 900 nm or less, and still more preferably 800 nm or less. The surface roughness (Ra) can be measured, for example, by using a non-contact type surface roughness meter.

At the step (i), instead of the resin sheet, the resin composition may be applied onto the inner layer substrate 200 using a die coater or the like followed by the thermal cure to form the cured product layer.

### <Step (ii)>

FIG. 11 is a schematic cross sectional view to explain the step (ii) in the production method of the circuit board according to the second example of one embodiment of the present invention. The step (ii) includes forming a hole in the first cured product layer 320 to form a via hole 360, as illustrated in FIG. 11. The via hole 360 forms a channel for electrically connecting the first conductor layer 420 and the second conductor layer 440 to be described later. Formation of the via hole 360 may be performed using, for example, drilling, a laser, or a plasma. The size and shape of the hole may be determined as appropriate in accordance with the design of the printed wiring board.

### <Step (iii)>

At the step (iii), the surface of the cured product layer in which the via hole is formed is subjected to a roughening treatment. The roughening treatment at the step (iii) may be performed in the same way as described at the step (4) of the first example.

From the viewpoint of improving the adhesion with the plating, the arithmetic average roughness (Ra) of the cured product layer after the roughening treatment is preferably 300 nm or more, more preferably 350 nm or more, and still more preferably 400 nm or more. The upper limit thereof is preferably 1500 nm or less, more preferably 1200 nm or less, and still more preferably 1000 nm or less. The surface roughness (Ra) can be measured, for example, by using a non-contact type surface roughness meter.

### <Step (iv)>

FIG. 12 is a schematic cross sectional view to explain the step (iv) in the production method of the circuit board according to the second example of one embodiment of the present invention. As illustrated in FIG. 12, at the step (iv), the second conductor layer 440 is formed on the first cured product layer 320.

The conductor material that can constitute the second conductor layer 440 may be, for example, the same as the material of the conductor layer described in the first example.

From the viewpoint of thinning, the thickness of the second conductor layer 440 is preferably 70 µm or less, more preferably 60 µm or less, still more preferably 50 µm or less, even still more preferably 40 µm or less, and especially preferably 30 µm or less, 20 µm or less, 15 um or less, or 10 µm or less. The lower limit thereof is preferably 1 µm or more, more preferably 3 µm or more, and still more preferably 5 um or more.

The second conductor layer 440 can be formed by plating. For example, the second conductor layer 440 is preferably formed by wet plating methods such as a semi-additive method that includes an electroless plating step, a mask patterning step, an electrolytic plating step, and a flash etching step, and a full-additive method. By forming the second conductor layer 440 by the wet plating method, the second conductor layer 440 having an intended wiring pattern can be formed. At this step, an inside-the-via-hole wiring 360a is also formed in the via hole 360.

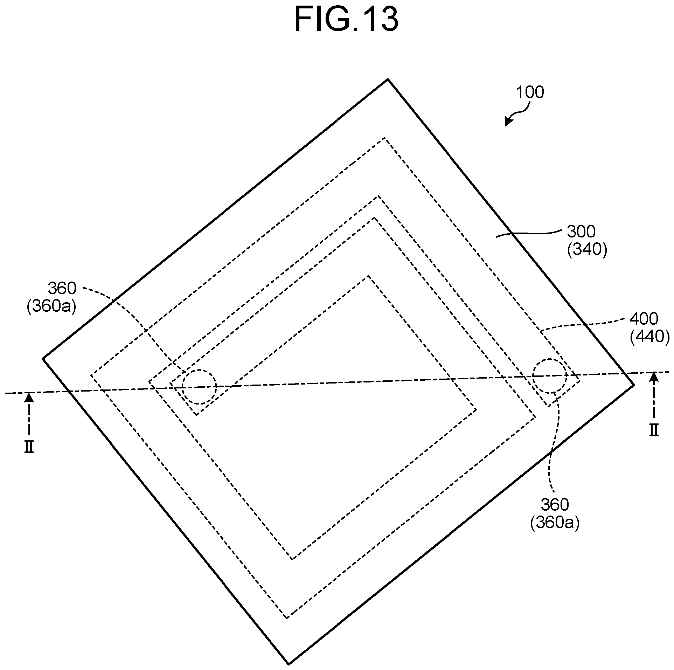

The first conductor layer 420 and the second conductor layer 440 may be formed in a spiral form, for example, as illustrated in FIGs. 13 to 15 to be described later as one example. In one example, one end of the central side of the spiral wiring portion of the second conductor layer 440 is electrically connected thorough the inside-the-via-hole wiring 360a to one end of the central side of the spiral wiring portion of the first conductor layer 420. The other end of the outer circumferential side of the spiral wiring portion of the second conductor layer 440 is electrically connected through the inside-the-via-hole wiring 360a to a land 420a of the first conductor layer 420. Therefore, the other end of the outer circumferential side of the spiral wiring portion of the second conductor layer 440 is electrically connected to the external terminal 240 via the inside-the-via-hole wiring 360a, the land 420a, and the inside-the-through-hole wiring 220a.

The coil-shaped conductive structural body 400 is composed of a spiral wiring portion that is a portion of the first conductor layer 420, a spiral wiring portion that is a portion of the second conductor layer 440, and the inside-the-via-hole wiring 360a that electrically connects the spiral wiring portion of the first conductor layer 420 with the spiral wiring portion of the second conductor layer 440.

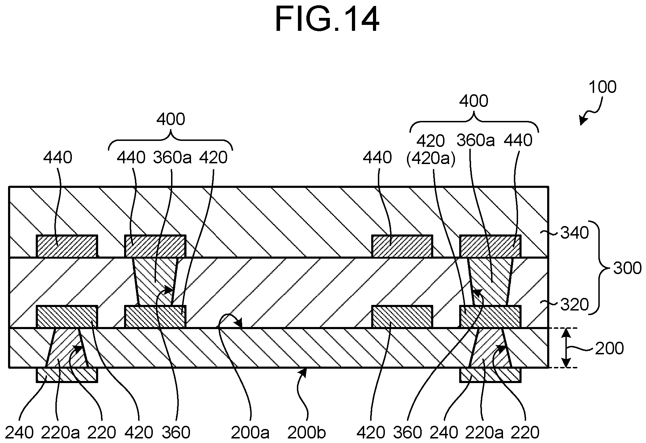

After the step (iv), a step of further forming the cured product layer on the conductor layer may be carried out. As illustrated in detail in FIG. 14 as one example, the second cured product layer 340 is formed on the second conductor layer 440 and the first cured product layer 320 in which the inside-the-via-hole wiring 360a is formed. The second cured product layer may be formed with the same step as the step that has already been described. By the method described above, a circuit board 100 including the first cured product layer 320 and the second cured product layer 340 formed of the cured product of the resin composition may can produced.

### <Inductor Substrate>

The inductor substrate includes the circuit board described above. When the inductor substrate includes the circuit board obtained by the production method of the circuit board according to the first example described above, the inductor substrate may have an inductor pattern formed by a conductor at least partially around the cured product of the resin composition. In this case, the inductor substrate may include an inductor element that is composed of an inductor pattern which is formed, for example, by at least a part of the metal layer 12, the metal layer 13, the plated layer 20, and the patterned conductor layer 41, and a core portion formed of the cured product 30 surrounded by the inductor pattern. As for the inductor substrate, the one that is described in Japanese Patent Application Laid-open No. 2016-197624 may be used, for example.

When the inductor substrate includes the circuit board obtained by the production method of the circuit board according to the second example, the inductor substrate may have the cured product layer and the conductive structural body having at least part thereof embedded in the cured product layer. The inductor substrate may include the inductor element composed of the conductive structural body and a part of the cured product layer that extends in the thickness direction of the cured product layer and is surrounded by the conductive structural body.

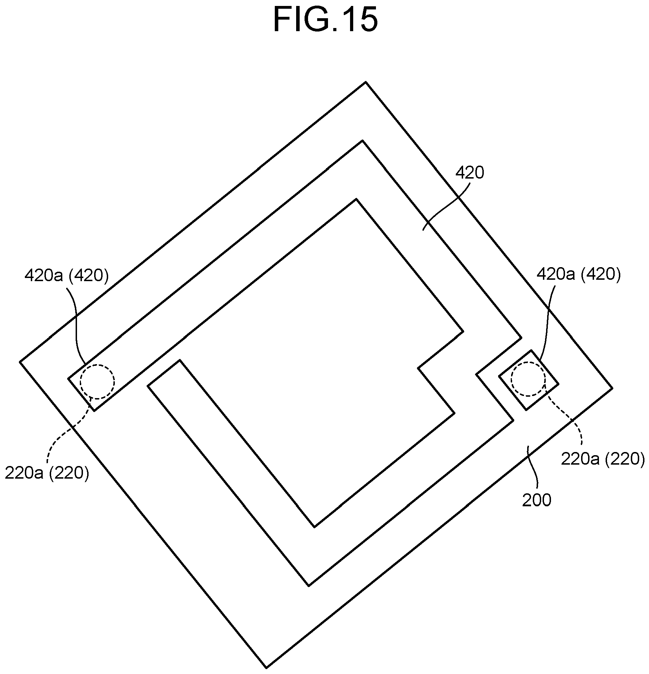

FIG. 13 is a schematic plan view of the circuit board 100 possessed by the inductor substrate, observed from one side in the thickness directions thereof. FIG. 14 is a schematic view illustrating the cut end face of the circuit board 100 cut at the position indicated by the II-II single-dotted line in FIG. 13. FIG. 15 is a schematic plan view to explain the composition of the first conductor layer 420 of the circuit board 100 included in the inductor substrate.

The circuit board 100 may be a substrate having a plurality of the cured product layers (the first cured product layer 320 and the second cured product layer 340) and a plurality of the conductor layers (the first conductor layer 420 and the second conductor layer 440), as illustrated in FIG. 13 and FIG. 14 as one example. Thus, in the example illustrated here, the circuit board 100 may be a build-up wiring board having a build-up cured product layer and a build-up conductor layer. The circuit board 100 has an inner layer substrate 200.

As illustrated in FIG. 14, the first cured product layer 320 and the second cured product layer 340 constitute the magnetic portion 300, which may be considered as an integral cured product layer. Therefore, the coil-shaped conductive structural body 400 is formed such that at least a part thereof is embedded in the magnetic portion 300. In other words, in the circuit board 100 illustrated in this example, the inductor element is composed of the coil-shaped conductive structural body 400 and the core portion, which is a part of the magnetic portion 300 that extends to the thickness direction of the magnetic portion 300 and is surrounded by the coil-shaped conductive structural body 400.

As illustrated in FIG. 15 as one example, the first conductor layer 420 includes a spiral wiring portion to constitute the coil-shaped conductive structural body 400 and the rectangular land 420a that is electrically connected to the inside-the-through-hole wiring 220a. In the example illustrated here, the spiral wiring portion includes straight portions, bending portions that bend at right angles, and a detour portion that detours the land 420a. The spiral wiring portion of the first conductor layer 420 has an overall outline of a substantially rectangular shape and has the shape that the wiring portion is whirled in a counterclockwise direction from the center side to the outer side thereof.

Similarly, the second conductor layer 440 is formed on the first cured product layer 320. The second conductor layer 440 includes the spiral wiring portion to form the coil-shaped conductive structural body 400. In FIG. 13 or FIG. 14, the spiral wiring portion includes the straight portions and the bending portions that bend at right angles. In Fig. 13 or Fig. 14, the spiral wiring portion of the second conductor layer 44 has an overall outline of a substantially rectangular shape and has the shape that the wiring portion is whirled in a clockwise direction from the center side to the outer side thereof.

The inductor substrate described above may be used as the wiring board to mount an electronic part such as a semiconductor chip, and may also be used as a (multilayered) printed wiring board that uses this wiring board as the inner layer substrate. In addition, the inductor substrate may be used as a chip inductor component obtained by dicing the wiring board, and may also be used as a printed wiring board that is surface-mounted with the chip inductor component.

By using this wiring board, semiconductor devices with various embodiments can be produced. The semiconductor device including the wiring board can be suitably used in electric products (for example, a computer, a mobile phone, a digital camera, and a television), vehicles (for example, a motor bike, an automobile, a train, a marine ship, and an airplane), and so forth.

### [EXAMPLES]

Hereinafter, the present invention will be described more specifically by means of Examples. The present invention is not limited to these Examples. In the description below, "%" and "part" that describe quantity mean "% by mass" and "parts by mass", respectively, unless otherwise specifically mentioned. When the temperature is not specified in particular, the temperature condition of room temperature (23°C) was used. When the pressure is not specified in particular, the pressure condition of a normal pressure (1 atm) was used.

### <Example 1: Production of Resin Composition Varnish 1>

55.09 parts by mass of the Fe-Ni-Si type alloy magnetic powder ("AKT-PB-3Si", manufactured by Mitsubishi Steel Mfg. Co. Ltd., alloy of 50% Fe, 47% Ni, and 3% Si, average particle diameter (D₅₀) of 5 µm, true density of 8.0 g/cm³), 21 parts by mass of the magnetic powder ("CVD Iron Powder 0.7um", manufactured by JFE Chemical Corp., Fe-Si-Cr type alloy powder, average particle diameter (D₅₀) of 0.7 um, true density of 6.9 g/cm³), 1.63 parts by mass of the epoxy resin ("ZX-1059", manufactured by Nippon Steel Chemical & Material Co., Ltd., a mixture of bisphenol A type epoxy resin and bisphenol F type epoxy resin, epoxy equivalent of 169 g/eq., true density of 1.2 g/cm³), 1.85 parts by mass of the phenol resin ("LA-7054", manufactured by DIC Corp., aminotriazine-modified phenol novolac resin, MEK solution with 60% nonvolatile component, hydroxyl group equivalent of 125 g/eq., true density of nonvolatile component of 1.2 g/cm³), 1.61 parts by mass of the phenoxy resin ("YX7553BH30", manufactured by Mitsubishi Chemical Corp., methyl ethyl ketone : cyclohexanone = 1:1 solution with 30% nonvolatile component: phenoxy resin having a special skeleton, true density of non-volatile component of 1.2 g/cm³), 0.67 parts by mass of the dispersant ("ED-152", manufactured by Kusumoto Chemicals, Ltd., polyether phosphate ester type dispersant, true density of 1.2 g/cm³), and 0.01 parts by mass of the curing accelerator ("TBP-DA", manufactured by Hokko Chemical Industry Co., Ltd., phosphorus type curing accelerator, true density of 1.2 g/cm³) were mixed and uniformly dispersed by means of a high-speed rotary mixer to prepare Resin Composition Varnish 1.

### <Example 2: Preparation of Resin Composition Varnish 2>

Resin Composition Varnish 2 was prepared in the same way as Example 1 except that, in place of 55.09 parts by mass of the Fe-Ni-Si type alloy magnetic powder ("AKT-PB-3Si", manufactured by Mitsubishi Steel Mfg. Co. Ltd., alloy of 50% Fe, 47% Ni, and 3% Si, average particle diameter (D₅₀) of 5 um, true density of 8.0 g/cm³), 53.52 parts by mass of the Fe-Ni-Si type alloy magnetic powder ("AKT-PB-6Si", manufactured by Mitsubishi Steel Mfg. Co., Ltd., alloy of 50% Fe, 44% Ni, and 6% Si, average particle diameter (D₅₀) of 5 um, true density of 7.8 g/cm³) was used.

### <Example 3: Preparation of Resin Composition Varnish 3>

93.33 parts by mass of the Fe-Ni-Si type alloy magnetic powder ("AKT-PB-3Si", manufactured by Mitsubishi Steel Mfg. Co., Ltd., alloy of 50% Fe, 47% Ni, and 3% Si, average particle diameter (D₅₀) of 5 µm, true density of 8.0 g/cm³), 27.95 parts by mass of the magnetic powder ("MZ03S", manufactured by Powdertech Co., Ltd., Mn-Zn type ferrite powder, average particle diameter (D₅₀) of 1.0 um, true density of 5.1 g/cm³), 2.31 parts by mass of the epoxy resin ("ZX-1059", manufactured by Nippon Steel Chemical & Material Co., Ltd., a mixture of bisphenol A type epoxy resin and bisphenol F type epoxy resin, epoxy equivalent of 169 g/eq., true density of 1.2 g/cm³), 2.63 parts by mass of the phenol resin ("LA-7054", manufactured by DIC Corp., aminotriazine-modified phenol novolac resin, MEK solution with 60% nonvolatile component, hydroxyl group equivalent of 125 g/eq., true density of nonvolatile component of 1.2 g/cm³), 2.02 parts by mass of the phenoxy resin ("YX7553BH30", manufactured by Mitsubishi Chemical Corp., methyl ethyl ketone : cyclohexanone = 1:1 solution with 300 nonvolatile component: phenoxy resin having a special skeleton, true density of non-volatile component of 1.2 g/cm³), 0.54 parts by mass of the dispersant ("PB-881", manufactured by Ajinomoto Fine Techno Co., Ltd., polyester type dispersant, true density of 1.2 g/cm³), and 0.02 parts by mass of the curing accelerator ("TBP-DA", manufactured by Hokko Chemical Industry Co., Ltd., phosphorus type curing accelerator, true density of 1.2 g/cm³) were mixed and uniformly dispersed by means of a high-speed rotary mixer to prepare Resin Composition Varnish 3.

### <Comparative Example 1: Preparation of Resin Composition Varnish 4>

Resin Composition Varnish 4 was prepared in the same way as Example 1 except that, in place of 55.09 parts by mass of the Fe-Ni-Si type alloy magnetic powder ("AKT-PB-3Si", manufactured by Mitsubishi Steel Mfg. Co. Ltd., alloy of 50% Fe, 47% Ni, and 3% Si, average particle diameter (D₅₀) of 5 um, true density of 8.0 g/cm³), 51.8 parts by mass of the Fe-Ni-Si type alloy magnetic powder ("AKT-PB-9Si", manufactured by Mitsubishi Steel Mfg. Co., Ltd., alloy of 50% Fe, 41% Ni, and 9% Si, average particle diameter (D₅₀) of 5um, true density of 7.6 g/cm³) was used.

### <Comparative Example 2: Preparation of Resin Composition Varnish 5>

Resin Composition Varnish 5 was prepared in the same way as Example 1 except that, in place of 55.09 parts by mass of the Fe-Ni-Si type alloy magnetic powder ("AKT-PB-3Si", manufactured by Mitsubishi Steel Mfg. Co. Ltd., alloy of 50% Fe, 47% Ni, and 3% Si, average particle diameter (D₅₀) of 5 um, true density of 8.0 g/cm³), 54.82 parts by mass of the Fe-Ni type alloy magnetic powder ("AKT-PB", manufactured by Mitsubishi Steel Mfg. Co., Ltd., alloy of 50% Fe and 50% Ni, average particle diameter (D₅₀) of 5 um, true density of 8.2 g/cm³) was used.

### <Comparative Example 3: Preparation of Resin Composition Varnish 6>

Resin Composition Varnish 6 was prepared in the same way as Example 1 except that, in place of 55.09 parts by mass of the Fe-Ni-Si type alloy magnetic powder ("AKT-PB-3Si", manufactured by Mitsubishi Steel Mfg. Co. Ltd., alloy of 50% Fe, 47% Ni, and 3% Si, average particle diameter (D₅₀) of 5 um, true density of 8.0 g/cm³), 60.16 parts by mass of the Ni type alloy magnetic powder ("AKT-78Ni-5Mo", manufactured by Mitsubishi Steel Mfg. Co., Ltd., alloy of 17% Fe, 78% Ni, and 5% Mo, average particle diameter (D₅₀) of 5 um, true density of 8.9 g/cm³) was used.

### <Comparative Example 4: Preparation of Resin Composition Varnish 7>

Resin Composition Varnish 7 was prepared in the same way as Example 1 except that, in place of 55.09 parts by mass of the Fe-Ni-Si type alloy magnetic powder ("AKT-PB-3Si", manufactured by Mitsubishi Steel Mfg. Co. Ltd., alloy of 50% Fe, 47% Ni, and 3% Si, average particle diameter (D₅₀) of 5 um, true density of 8.0 g/cm³), 47 parts by mass of the Fe-Si-Cr type alloy magnetic powder ("AW2-08PF3F", manufactured by Epson Atmix Corp., alloy of Fe-Si-Cr, average particle diameter (D₅₀) of 3.5 um, true density of 7.0 g/cm³) was used.

### <Comparative Example 5: Preparation of Resin Composition Varnish 8>

Resin Composition Varnish 8 was prepared in the same way as Example 1 except that, in place of 55.09 parts by mass of the Fe-Ni-Si type alloy magnetic powder ("AKT-PB-3Si", manufactured by Mitsubishi Steel Mfg. Co. Ltd., alloy of 50% Fe, 47% Ni, and 3% Si, average particle diameter (D₅₀) of 5 µm, true density of 8.0 g/cm³), 69 parts by mass of the Fe-Si-Cr type alloy magnetic powder ("AW2-08PF3F", manufactured by Epson Atmix Corp., alloy of Fe-Si-Cr, average particle diameter (D₅₀) of 3.5 um, true density of 7.0 g/cm³) was used.

### <Production of Resin Sheet>

Each of the resin composition varnishes prepared in the respective Examples and Comparative Examples was applied onto a polyethylene terephthalate (hereinafter, this is referred to as "PET") film (thickness: 38 µm) as a support using a die coater such that the thickness of the resin composition layer after drying became 100 µm to form the resin composition layer. This was then dried in the temperature range of 75°C to 120°C (average 100°C) for 7 minutes such that the amount of the residual solvent in the resin composition layer became about 0.4% by mass or less to obtain the resin sheet.

### <Preparation of Sheet-shaped Cured Product>

The resin sheet prepared using the resin composition varnish prepared in respective Examples and Comparative Examples was heated at 190°C for 90 minutes to thermally cure the resin composition layer. The PET film as the support was removed to obtain the cured product in the shape of a sheet.

### <Test Example: Evaluation of Magnetic Properties>

The cured product in the shape of a sheet thus obtained was cut to obtain the evaluation sample having a width of 5 mm and a length of 18 mm. The relative magnetic permeability (µ') and the magnetic loss (µ") of the evaluation sample were measured at room temperature of 23°C by the 3-turn coil method with a measurement frequency of 20 MHz by using Agilent Technologies ("HP8362B" manufactured by Agilent Technologies, Inc.). The magnetic loss tangent tanδ was calculated from the formula [tanδ=µ"/µ'].

The evaluation criteria for the relative magnetic permeability are as follows.
"O": Relative magnetic permeability is 15 or more.
"X": Relative magnetic permeability is less than 15.

The evaluation criteria for the magnetic loss tangent are as follows.
"O": magnetic loss tangent is 0.02 or less.
"X": magnetic loss tangent is more than 0.02.

### [Results]

The results of Examples and Comparative Examples are summarized in Table below.

**[Table 1]**

| **Table 1. Results of Examples and Comparative Examples]** | | | | | | | | |
|---|---|---|---|---|---|---|---|---|
| | Example | | | Comparative Example | | | | |
| | 1 | 2 | 3 | 1 | 2 | 3 | 4 | 5 |
| (A) | | | | | | | | |
| AKT-PB-3Si | 55.09 | | 93.33 | | | | | |
| AKT-PB-6Si | | 53.52 | | | | | | |
| (C) | | | | | | | | |
| AKT-PB-9Si | | | | 51.8 | | | | |
| AKT-PB | | | | | 54.82 | | | |
| AKT-78Ni-5Mo | | | | | | 60.16 | | |
| AW2-08PF3F | | | | | | | 47 | 69 |
| CVD Iron Powder 0.7µm | 21 | 21 | | 21 | 21 | 21 | 21 | 21 |
| MZ03S | | | 27.95 | | | | | |
| (B) | | | | | | | | |
| ZX-1059 | 1.63 | 1.63 | 2.31 | 1.63 | 1.63 | 1.63 | 1.63 | 1.63 |
| LA-7054 | 1.85 | 1.85 | 2.63 | 1.85 | 1.85 | 1.85 | 1.85 | 1.85 |
| (D) | | | | | | | | |
| YX7553BH30 | 1.61 | 1.61 | 2.02 | 1.61 | 1.61 | 1.61 | 1.61 | 1.61 |
| (E) | | | | | | | | |
| ED-152 | 0.67 | 0.67 | | 0.67 | 0.67 | 0.67 | 0.67 | 0.67 |
| PB-881 | | | 0.54 | | | | | |
| (F) | | | | | | | | |
| TBP-DA | 0.01 | 0.01 | 0.02 | 0.01 | 0.01 | 0.01 | 0.01 | 0.01 |
| Total amount of nonvolatile components | 79.99 | 78.42 | 126.33 | 76.70 | 79.72 | 85.06 | 71.90 | 93.90 |
| Amount of magnetic powder (% by weight) | 95.12 | 95.02 | 96.00 | 94.91 | 95.10 | 95.41 | 94.57 | 95.84 |
| Amount of magnetic powder (% by volume) | 75.33 | 75.28 | 80.28 | 75.19 | 74.94 | 75.09 | 75.00 | 79.86 |
| Relative magnetic permeability | 17.34 | 15.18 | 18.4 | 14.05 | 17.94 | 18.49 | 14.7 | 18.2 |
| tanδ | 0.009 | 0.009 | 0.015 | 0.007 | 0.021 | 0.031 | 0.023 | 0.043 |
| Judgement of magnetic permeability | O | O | O | X | O | O | X | O |
| Judgement of magnetic loss tangent | O | O | O | O | X | X | X | X |

### Reference Signs List

1 Circuit board
10 Core substrate
11 Supporting substrate
12 Metal layer
13 Metal layer
14 Through hole
20 Plated layer
21 Surrounding surface of polished surface
30 Cured product
30a Resin composition
31 Polished surface of cured product (polished surface)
40 Conductor layer
41 Patterned conductor layer
100 Circuit board
200 Inner layer substrate
200a First main surface
200b Second main surface
220 Through hole
220a Inside-the-through-hole wiring
240 External terminal
310 Resin Sheet
320 First cured product layer
320a Resin composition layer
330 Support
360 Via hole
360a Inside-the-via-hole wiring
400 Coil-shaped conductive structural body
420 First conductor layer
420a Land
440 Second conductor layer

## Claims

1. A resin composition comprising (A) a Fe-Ni-Si type alloy magnetic powder and (B) a thermosetting resin, wherein
an amount of Si included in the (A) component is 1% by mass to 8% by mass relative to 100% mass of the (A) component.

2. The resin composition according to claim 1, wherein an amount of the (A) component is 40% by mass or more relative to 100% by mass of nonvolatile components in the resin composition.

3. The resin composition according to claim 1, wherein an amount of the (A) component is 30% by volume or more relative to 100% by volume of nonvolatile components in the resin composition.

4. The resin composition according to claim 1, wherein an average particle diameter of the (A) component is 1 µm or more.

5. The resin composition according to claim 1, wherein an average particle diameter of the (A) component is 10 µm or less.

6. The resin composition according to claim 1, further comprising (C) a magnetic powder other than the Fe-Ni-Si type alloy magnetic powder.

7. The resin composition according to claim 6, wherein the (C) component comprises an alloy magnetic powder other than the Fe-Ni-Si type alloy magnetic powder.

8. The resin composition according to claim 6, wherein the (C) component comprises a ferrite type magnetic powder.

9. The resin composition according to claim 6, wherein the (C) component comprises a ferrite type magnetic powder containing at least one element selected from the group consisting of Mn, Zn, Ni, and Cu.

10. The resin composition according to claim 6, wherein the (C) component has a smaller average particle diameter than the (A) component.

11. The resin composition according to claim 6, wherein a ratio of an average particle diameter of the (C) component with respect to an average particle diameter of the (A) component (average particle diameter of the (C) component / average particle diameter of the (A) component) is 0.001 to 0.9.

12. The resin composition according to claim 6, wherein a volume ratio ((C) component / (A) component) of the (C) component with respect to the (A) component is 0.01 to 0.9.

13. The resin composition according to claim 6, wherein a total amount of the (A) component and the (C) component is 70% by mass or more relative to 100% by mass of nonvolatile components in the resin composition.

14. The resin composition according to claim 6, wherein a total amount of the (A) component and the (C) component is 50% by volume or more relative to 100% by volume of nonvolatile components in the resin composition.

15. The resin composition according to claim 1, wherein the (B) component comprises an epoxy resin.

16. The resin composition according to claim 1, further comprising (D) a thermoplastic resin.

17. The resin composition according to claim 1, wherein the resin composition is for filling of a hole.

18. A cured product of the resin composition according to any one of claims 1 to 17.

19. A magnetic paste comprising the resin composition according to any one of claims 1 to 17.

20. A resin sheet comprising:
a support; and
a resin composition layer formed on the support, wherein
the resin composition layer comprises the resin composition according to any one of claims 1 to 17.

21. A circuit board comprising:
a substrate having a hole; and
a cured product of the resin composition according to any one of claims 1 to 17 filled in the hole.

22. A circuit board comprising a cured product layer that comprises a cured product of the resin composition according to any one of claims 1 to 17.

23. An inductor substrate comprising the circuit board according to claim 21 or 22.
